# EUROPEAN PATENT SPECIFICATION

(11) **EP 3 061 331 B1**
(45) Date of publication and mention of the grant of the patent: **06.09.2017**
(21) Application number: 13799115.4
(22) Date of filing: 21.10.2013
(51) Int. Cl.: H05K 13/04

(54) **METHOD FOR MOUNTING AN ELECTRONIC-COMPONENT ONTO A SUBSTRATE AND ELECTRONIC-COMPONENT MOUNTING MACHINE**
VERFAHREN ZUR MONTAGE EINER ELEKTRONISCHEN KOMPONENTE AUF EIN SUBSTRAT UND MONTAGEMASCHINE FÜR ELEKTRONISCHE KOMPONENTE
PROCÉDÉ DE MONTAGE D'UN COMPOSANT ÉLECTRONIQUE SUR UN SUBSTRAT ET MACHINE DE MONTAGE DE COMPOSANT ÉLECTRONIQUE

(43) Date of publication of application: 31.08.2016
(73) Proprietor: Fuji Machine Mfg. Co., Ltd., Chiryu-shi, Aichi 472-8686 (JP); ETEL S.A., 2112 Môtiers (CH)
(72) Inventor: KAWAGUCHI, Koji, Chiryu-shi Aichi 472-8686 (JP); KUNZE, Marc, CH-1373 Chavornay (CH); FELLAY, Fabien, CH-1920 Martigny (CH); SUDAN, Jacques-André, CH-2016 Cortaillod (CH)
(74) Representative: Grünecker Patent- und Rechtsanwälte PartG mbB
(86) International application number: PCT/JP2013/079328
(87) International publication number: WO 2015/059839

(56) References cited:
- DE-A1- 10 341 046
- US-A1- 2003 014 862
- US-B1- 6 282 779

## Description

### TECHNICAL FIELD

The present invention relates to a method for mounting an electronic component onto a substrate (hereinafter referred to simply as "component mounting method" unless otherwise required by context) and to an electronic-component mounting machine (hereinafter referred to simply as "mounting machine" unless otherwise required by context) including a suction nozzle that uses negative pressure to suck and hold an electronic component (hereinafter referred to simply as "component" unless otherwise required by context) and mount the component on a substrate.

### BACKGROUND ART

The patent document JP-A-11-145683 discloses a mounting machine configured to control a linear motor to lower a suction nozzle and mount a component onto a circuit board. Until the component sucked and held by the suction nozzle is brought into contact with the circuit board, this mounting machine controls the linear motor to control a speed of the lowering of the suction nozzle and a position to which the suction nozzle is to be lowered. After the contact, the mounting machine controls the linear motor to control a pressing force with which the component is pressed against the circuit board. These controls reduce impact given to the component upon mounting, enabling the component to be mounted on the substrate with an accurate pressing force.

The documents US2003/0014862 A1 and DE 103 41 046 A1 disclose the mounting of electric components to a substrate using a nozzle and a nozzle advancing device, wherein the nozzle can be connected to a negative pressure supply source and a negative pressure elimination source via a valve device.

### SUMMARY OF THE INVENTION

### PROBLEM TO BE SOLVED BY THE INVENTION

This invention has been developed in view of the above-described situations, and it is an objective of the present invention to provide a method for improved mounting of an electronic-component onto a substrate and a mounting machine having improved utility

### MEANS FOR SOLVING PROBLEM

The present invention can provide a method for mounting a component to a substrate by means of a suction nozzle configured to suck and hold a component using negative pressure, wherein upon elimination of the negative pressure for releasing the component from the suction nozzle, a force for pressing the component against the substrate is made appropriate.

The force for pressing the component against the substrate due to the elimination of the negative pressure includes at least one of a force for advancing the suction nozzle and a force for releasing the component from the suction nozzle. For example, in a case where the suction nozzle and a nozzle holder are fitted to each other at a mating portion so as to be movable relative to each other, and the negative pressure is supplied to the suction nozzle via the mating portion, the nozzle advancing force increases with the elimination of the negative pressure. In a case where the suction nozzle is fixed to the nozzle holder, on the other hand, the nozzle advancing force does not increase with the elimination of the negative pressure. Also, it is obvious that the component releasing force is produced in a case where the negative pressure is eliminated by "vacuum break" that eliminates the negative pressure by supplying positive pressure to the suction nozzle. Even in a case where the negative pressure is eliminated simply by connecting the suction nozzle to atmosphere, when the suction nozzle is suddenly connected to atmosphere, the component releasing force may be produced due to overshoots in pressure in the suction nozzle.

The present invention can also provide an electronic-component mounting machine comprising: a suction nozzle configured to suck and hold an electronic component using negative pressure; and a nozzle advancing device comprising at least an actuator, the electronic-component mounting machine being configured to: have the nozzle advancing device advance the suction nozzle holding the electronic component to press the electronic component against a substrate; and eliminate the negative pressure in the suction nozzle to release the electronic component and mount the electronic component on the substrate, the electronic-component mounting machine further comprising: (A) a valve device provided between (i) the suction nozzle and (ii) a negative-pressure supply source configured to supply the negative pressure and a negative-pressure eliminating source configured to eliminate the negative pressure, the valve device being configured to control supply of the negative pressure to the suction nozzle and elimination of the negative pressure; and (B) a control device configured to control the valve device and the nozzle advancing device, the control device comprising: (a) a negative pressure eliminator configured to control the valve device to have the suction nozzle release the component; and (b) an elimination effect reducer configured to control the nozzle advancing device to eliminate at least a portion of effect of the negative-pressure elimination caused by the negative pressure eliminator, on a pressing force with which the component is pressed against the substrate. The negative-pressure eliminating source includes at least one of an atmospheric pressure source for supplying atmospheric pressure and a positive pressure supply source for supplying positive pressure.

Examples of the substrate include (1) a printed wiring board on which no components have been mounted yet, (2) a printed circuit board having: one side on which components have been mounted and electrically bonded; and the other side on which no components have been mounted, (3) a substrate on which bare chips are to be mounted and which constitutes a chip-mounted board, (4) a substrate on which a component with a ball grid array is to be mounted, (5) a substrate having a three-dimensional shape instead of a planar plate shape, and (6) a substrate on which a die is mounted during assembly of an IC package.

Examples of the component include: passive components such as resistances and capacitors; active components such as ICs; and dies.

Examples of the actuator include a linear motor and a rotation motor each as one kind of an electric motor. The nozzle advancing device may include only the actuator or may include, in addition to the actuator, at least an urging member for urging the suction nozzle in one of a forward direction and a backward direction. In a case where the weight of the suction nozzle acts in the direction in which the suction nozzle is moved forward, the weight may be considered as a part of the nozzle advancing device or may be neglected.

### EFFECT OF THE INVENTION

When the component is mounted on the substrate, the vacuum break caused by sudden connection of the suction nozzle to atmosphere or supply of positive pressure to the suction nozzle is preferably implemented to cause the suction nozzle to release the component speedily and reliably. However, the pressing force with which the component is pressed against the substrate changes due to this vacuum break. This change may hinder good mounting of the component, and in a case where the pressing force changes considerably, this change may break the component and/or the substrate.

In the component mounting method according to the present invention, however, the force for pressing the component against the substrate is made appropriate upon elimination of the negative pressure for releasing the component from the suction nozzle. Also, in the mounting machine according to the present invention, the valve device and the nozzle advancing device are controlled to eliminate at least a portion of effect of the negative-pressure elimination caused by the negative pressure eliminator, on a pressing force with which the component is pressed against the substrate, whereby the component is pressed against the substrate with an appropriate pressing force.

### BRIEF DESCRIPTION OF THE DRAWINGS

Fig. 1 is a plan view illustrating a mounting machine according to one embodiment of the present invention, wherein a component mounting method according to one embodiment of the present invention is implemented by the mounting machine.
Fig. 2 is a side view (partly in cross section) illustrating a portion of a head moving device and a mounting head of the mounting machine.
Fig. 3 is a view illustrating a suction nozzle of the mounting head and components near the nozzle, wherein Fig. 3(a) is a partially cross-sectional side view, and Fig. 3(b) is a view seen from A.
Fig. 4 is a block diagram illustrating a control system for a linear motor of the mounting head and a valve device of the mounting machine.
Fig. 5 is a graph illustrating a reaction force applied to the linear motor and a pressing force applied to a component when the mounting head mounts the component on a circuit board.
Fig. 6 is a block diagram illustrating a control system of a mounting machine according to another embodiment of the present invention.
Fig. 7 is a graph illustrating a relationship between a component pressing force and a length of time elapsed from switching of the valve device, which are obtained for setting a set length of time and a component-pressing-force reducing amount used for a pressing force control executed by the control system illustrated in Fig. 6.
Fig. 8 is a block diagram illustrating a control system of a mounting machine according to yet another embodiment of the present invention.
Fig. 9 is a graph illustrating a relationship between a displacement of a suction nozzle when a mounting head mounts a component on a circuit board and a reaction force applied to the suction nozzle.
Fig. 10 is a side view (partly in cross section) illustrating a suction nozzle and components near the nozzle of a mounting head of a mounting machine according to yet another embodiment of the present invention.
Fig. 11 is a side view (partly in cross section) illustrating a suction nozzle and components near the nozzle of a mounting head of a mounting machine according to yet another embodiment of the present invention.
Fig. 12 is a block diagram illustrating a control system of a mounting machine according to yet another embodiment of the present invention.
Fig. 13 is a block diagram illustrating a control system of a mounting machine according to yet another embodiment of the present invention.
Fig. 14 is a block diagram illustrating a control system of a mounting machine according to yet another embodiment of the present invention.

### EMBODIMENTS

Hereinafter, there will be described embodiments of the present invention by reference to the drawings. It is to be understood that the present invention is not limited to the embodiments described below, and may be otherwise embodied with various changes and modifications which may occur to those skilled in the art.

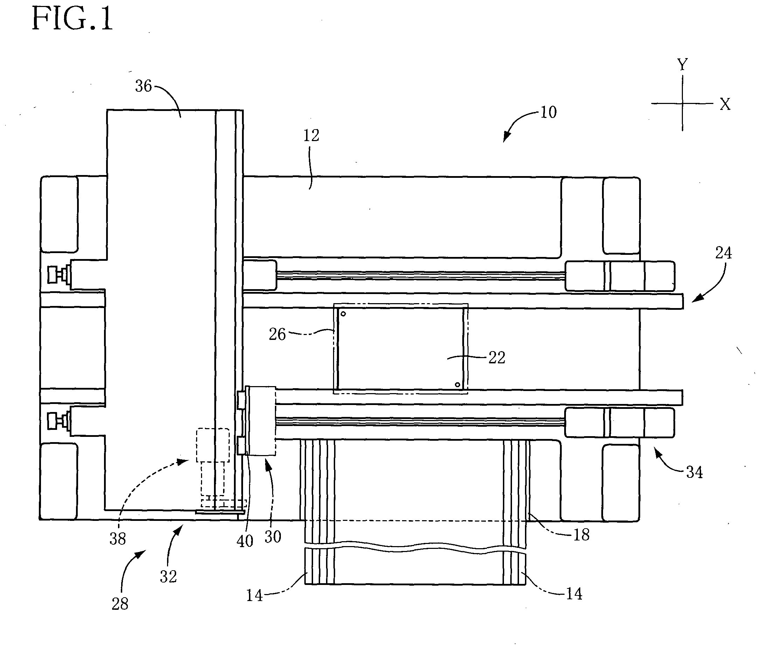

Fig. 1 illustrates a mounting machine 10. The mounting machine 10 includes a mounting-machine main body 12 and component supply devices in the form of tape feeders 14 supported on the mounting-machine main body 12. Each of the tape feeders 14 includes a reel and a tape for removably holding electronic components (each hereinafter referred to simply as "component") of one kind. Each tape feeder 14 unrolls the tape from the reel, carries the tape by one pitch at each carrying, and supplies the component at a predetermined supply position. These tape feeders 14 are provided on a support table 18 so as to be arranged next to each other in an X-axis direction.

Also provided on the mounting-machine main body 12 are a substrate conveyor device in the form of a board conveyor 24, a substrate holding device in the form of a board holding device 26, and a mounting device 28. The board conveyor 24 conveys a circuit board 22 (hereinafter referred to simply as "board 22") in the X-axis direction. The board holding device 26 positions and holds the board 22 conveyed. The mounting device 28 receives the components from the tape feeders 14 and mounts or places the components onto the board 22 held by the board holding device 26. In the present embodiment, the circuit board collectively covers a printed wiring board and a printed circuit board.

The mounting device 28 includes a mounting head 30 and a head moving device 32 capable of moving the mounting head 30 to any position in a horizontal plane that is one plane defined by an X axis and a Y axis. The head moving device 32 includes: an X axis slide 36 that is moved on the mounting-machine main body 12 in the X-axis direction by an X-axis drive device 34; and a Y-axis slide 40 that is moved on the X axis slide 36 in a Y-axis direction by a Y-axis drive device 38. The mounting head 30 is held by the Y-axis slide 40 so as to be movable to any position in the horizontal plane defined by X-Y coordinates.

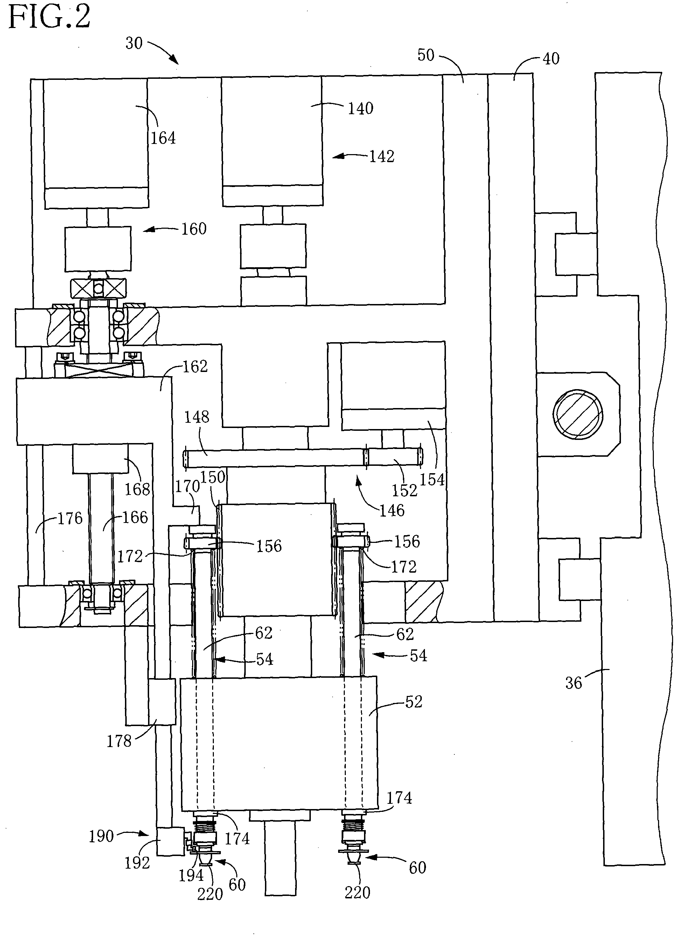

Fig. 2 illustrates one example of the mounting head 30. The mounting head 30 includes a head main body 50 detachably provided on the Y-axis slide 40 in the present embodiment and holding a rotary body 52 such that the rotary body 52 is rotatable about its rotation axis extending vertically. The rotary body 52 holds first up/down members in the form of rotatable up/down shafts 54 respectively at a plurality of positions spaced apart from each other along a circle centered about a rotation axis of the rotary body 52, in the present embodiment, equiangularly spaced apart from each other about the rotation axis. Each of the rotatable up/down shafts 54 is rotatable about its rotation axis and slidable in a direction parallel to its rotation axis and the rotation axis of the rotary body 52.

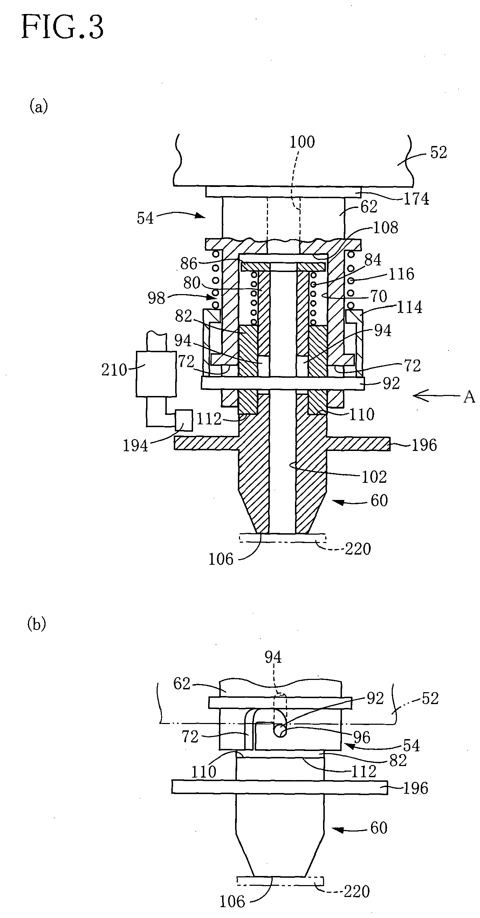

Each of the six rotatable up/down shafts 54 extends downward from the rotary body 52 and holds at its lower end portion a suction nozzle 60 that constitutes a component holder. In the present embodiment, the suction nozzles 60 of the same type are respectively held by the six rotatable up/down shafts 54. The type of the suction nozzles 60 depends upon a diameter (e.g., an outside diameter) of a suction face. As illustrated in the enlarged view of Fig. 3(a), each of the rotatable up/down shafts 54 has a main body or an up/down-shaft main body 62 whose lower end portion has a blind mating hole 70 opening its lower end face. The mating hole 70 is surrounded by a wall portion of the up/down-shaft main body 62 so as to have a round shape in transverse cross section, i.e., in cross section perpendicular to an axial direction of the rotatable up/down shaft 54, and the wall portion has cutouts 72 that are spaced apart from each other in a diameter direction. As illustrated in Fig. 3(b), each of the cutouts 72 extends upward from the lower end face of the up/down-shaft main body 62, curves at a right angle to extend in a circumferential direction, and curves again to extend downward for a short distance.

As illustrated in Fig. 3(a), each suction nozzle 60 includes a shaft portion 80, and a mating member 82 is fitted on an outer face of the shaft portion 80 so as to be movable relative to the shaft portion 80 in the axial direction. The mating member 82 has a cylindrical shape. After the shaft portion 80 is fitted in and inserted through the mating member 82, a compression coil spring 84 is fitted. A flange member 86 is fixed to an upper end of the shaft portion 80. The compression coil spring 84 is one example of a spring as an elastic member that is one kind of an urging member, and this applies to other compression coil springs described below. The compression coil spring 84 will be hereinafter referred to simply as "spring 84".

A pin 92 is secured to the mating member 82 so as to extend through the mating member 82 in its diameter direction. The pin 92 has an intermediate portion slidably extending through a pair of elongate holes 94 that are formed in the shaft portion 80 of the suction nozzle 60 so as to be elongated in the axial direction. The pin 92 further has opposite end portions projecting from an outer circumferential surface of the mating member 82. The mating member 82 fitted on the suction nozzle 60 is inserted in the up/down-shaft main body 62 together with the suction nozzle 60 from a lower end opening of the mating hole 70, then rotated at a specific angle, and then lowered. With these operations, the opposite end portions of the pin 92 respectively enter into the cutouts 72, then are engaged with the respective cutouts 72, and finally as illustrated in Fig. 3(b) received by pin receivers 96 of the respective cutouts 72 which extend downward for a short distance. In this state, the pin 92 extends through the up/down-shaft main body 62, the mating member 82, and the shaft portion 80 of the suction nozzle 60, preventing these three components from rotating relative to each other. Thus, when the rotatable up/down shaft 54 is rotated, the suction nozzle 60 is rotated together. In the present embodiment, the lower end portion of the up/down-shaft main body 62 and the mating member 82 constitute a nozzle holder, and the lower end portion of the upldown-shaft main body 62, the mating member 82, and the shaft portion 80 of the suction nozzle 60 constitute a mating portion 98 in which the nozzle holder holds the suction nozzle.

As illustrated in Fig. 3(a), the up/down-shaft main body 62 has a central portion in which is formed a negative pressure/positive pressure passage 100 communicating with the mating hole 70. The suction nozzle 60 has a central portion through which is formed a negative pressure/positive pressure passage 102 communicating with the mating hole 70. The negative pressure/positive pressure passage 102 opens in a lower end face of the suction nozzle 60 or a suction face 106 that has an annular shape surrounding the negative pressure/positive pressure passage 102. In the above-described state in which the mating member 82 is fitted in the mating hole 70, and the pin 92 is received by the pin receivers 96, the flange member 86 is spaced apart from a stepped face 108 formed in a boundary between the mating hole 70 and the negative pressure/positive pressure passage 100, and the suction nozzle 60 is urged by the spring 84 such that a stepped face 110 of the suction nozzle 60 is urged to a lower end face 112 of the mating member 82, so that the stepped face 110 is kept pressed against the lower end face 112. This lower end face 112 constitutes a stopper that defines an upward movement limit, i.e., a retracting limit or a backward movement limit of the suction nozzle 60 with respect to the nozzle holder.

The negative pressure/positive pressure passage 100 communicates with the mating hole 70 as described above. Thus, when negative pressure is supplied to the negative pressure/positive pressure passage 100, a force that elevates the suction nozzle 60 and the mating member 82 is applied to them, but a lock mechanism is provided to prevent the pin 92 from separating from the pin receivers 96 due to this force. That is, a lock sleeve 114 is slidably fitted on an outer circumferential surface of the up/down-shaft main body 62, and a compression coil spring 116 (hereinafter referred to simply as "spring 116") urges this lock sleeve 114 downward to press the pin 92 against the pin receivers 96.

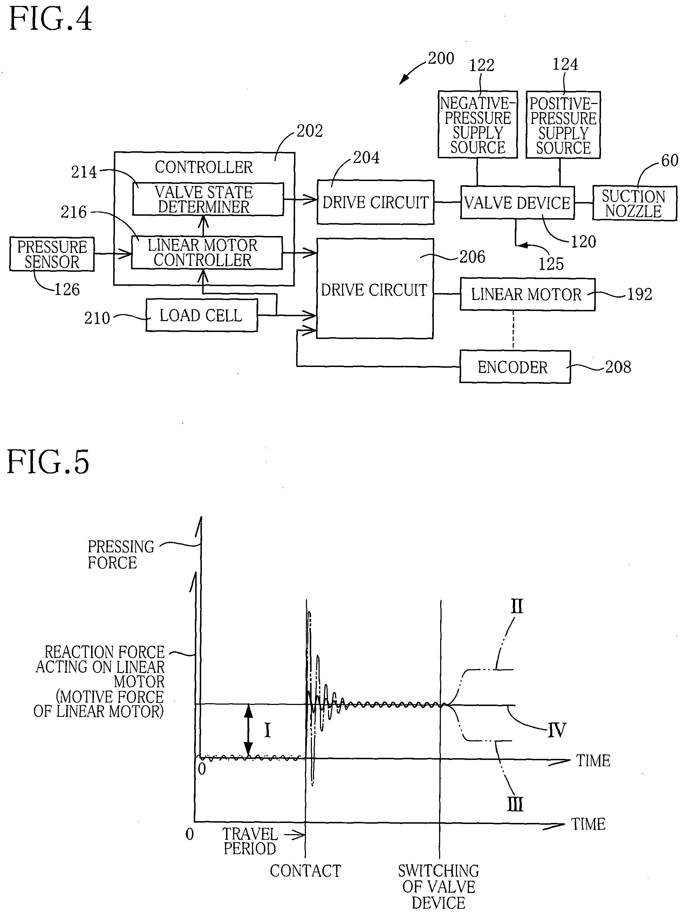

For the respective six suction nozzles 60, the rotary body 52 is provided with valve devices 120 (see Fig. 4), individual negative-pressure passages, not shown, individual positive-pressure passages, not shown, and the individual air passages, not shown. The six individual negative-pressure passages are connected to a negative-pressure supply source 122 (see Fig. 4) by a common negative-pressure passage, not shown, formed in the head main body 50. The six individual positive-pressure passages are connected to a positive-pressure supply source 124 (see Fig. 4) by a common positive-pressure passage, not shown, formed in the head main body 50. Each of the six individual air passages is open to the atmosphere at an air communication opening 125 (see Fig. 4). In the present embodiment, the air communication opening 125 constitutes an atmospheric pressure source.

The valve devices 120 are provided between the negative pressure/positive pressure passage 100 and the respective individual negative-pressure passages, the respective individual positive-pressure passages, and the respective individual air passages. In the present embodiment, each of the valve devices 120 is constituted by one or two electromagnetic spool valves and switched between a negative-pressure supply state in which the suction nozzle 60 communicates with the individual negative-pressure passage and the negative-pressure supply source 122, a positive-pressure supply state in which the suction nozzle 60 communicates with the individual positive-pressure passage and the positive-pressure supply source 124, and an atmospheric open state in which the suction nozzle 60 is connected to the individual air passage to be open to the atmosphere. Current is supplied individually to the six valve devices 120, specifically, electromagnets of the electromagnetic spool valves. Control of supplying or not supplying the current to the valve devices 120 is executed on a head-main-body side, so that the six valve devices 120 are switched individually.

Provided in the rotary body 52 are pressure sensors 126 (one of which is illustrated in Fig. 4) respectively for the six suction nozzles 60. Each of the pressure sensors 126 detects pressure in a passage, not shown, that is formed in the rotary body 52 to connect between the negative pressure/positive pressure passage 100 of the rotatable up/down shaft 54 and the valve device 120. This passage is located near the mating hole 70 communicating with the negative pressure/positive pressure passage 100. Thus, the pressure sensor 126 substantially detects pressure that can be considered to be equal to pressure in the mating portion 98. The pressure in the mating portion 98 can also be considered to be equal to pressure in the suction nozzle 60, so that the pressure detected by the pressure sensor 126 also is the pressure in the suction nozzle 60.

As illustrated in Fig. 2, a rotary-body rotating motor 140 is provided for driving a rotary-body rotating device 142 that rotates the rotary body 52 at any angle in forward and reverse directions, so that the plurality of suction nozzles 60 are revolved around the rotation axis of the rotary body 52. Each suction nozzle 60 is rotated about its own rotation axis by a component-holder rotating device in the form of a nozzle rotating device 146. Gears 148, 150 are integrally and rotatably fitted on an outer circumferential surface of the rotary body 52 and rotated by a nozzle rotating motor 154 via a pinion 152 to rotate the rotatable up/down shafts 54 in union respectively via a plurality of pinions 156. The rotations of the rotatable up/down shafts 54 are transferred to the mating member 82 by the engagement between the pin 92 and the pin receivers 96 and then transferred to the suction nozzles 60 by the engagement between the pin 92 and the elongate holes 94, so that the six suction nozzles 60 are rotated in union. In view of the above, the nozzle rotating device 146 is constituted by the nozzle rotating motor 154, the gears 148, 150, and the pinions 152, 156.

The present mounting head 30 receives the component from the tape feeder 14 and mounts the component onto the board 22 at the same position in a revolving path of the suction nozzle 60. This position will be hereinafter referred to as "component receiving/mounting position". After the rotation of the rotary body 52, one of the six rotatable up/down shafts 54 which has been moved to the component receiving/mounting position is elevated or lowered with respect to the head main body 50 by a first elevating and lowering device 160 illustrated in Fig. 2.

In the present embodiment, the first elevating and lowering device 160 includes: a second up/down member in the form of an elevating and lowering member 162; a rotation motor in the form of an elevating and lowering motor 164; a feed screw 166; and a nut 168. The elevating and lowering member 162 extends outside the rotary body 52 in the up and down direction along the rotatable up/down shafts 54. The elevating and lowering member 162 is fixed at its upper end portion to the nut 168 and includes a first engaging portion 170 at an intermediate portion of the elevating and lowering member 162. Each rotatable up/down shaft 54 is urged upward by a compression coil spring 172, and since a snap ring 174 attached near a lower end of the rotatable up/down shaft 54 is held in contact with a lower face of the rotary body 52, the rotatable up/down shaft 54 is positioned at its upper limit position. Accordingly, when lowered, the first engaging portion 170 of the elevating and lowering member 162 is engaged with an upper end face of the rotatable up/down shaft 54 to lower the rotatable up/down shaft 54 against the urging force of the compression coil spring 172, and, when elevated, the first engaging portion 170 allows the upward movement of the rotatable up/down shaft 54. It is noted that the elevating and lowering member 162 is elevated and lowered while guided by a guide rod 176 and a guide 178.

As illustrated in Fig. 2, the elevating and lowering member 162 holds, at its lower end portion, a second elevating and lowering device 190 that is elevated and lowered with the rotatable up/down shaft 54. In the present embodiment, the second elevating and lowering device 190 constitutes an actuator driven by a linear motor 192. The linear motor 192 includes a second engaging portion 194 (see Fig. 3(a)). The second engaging portion 194 is constituted by a roller rotatable about a horizontal axis. With the rotatable up/down shaft 54 located at the upper limit position, the second engaging portion 194 is located above a flange 196 of the suction nozzle 60 with a space therebetween, allowing the rotation and revolution of the suction nozzle 60.

The linear motor 192 is controlled by a control system 200 illustrated in Fig. 4. The control system 200 is constituted by: a portion of a controller 202 which controls the entire mounting machine including the mounting device 28; drive circuits 204, 206; an encoder 208 attached to the linear motor 192; a load cell 210; and the pressure sensor 126. The controller 202 controls a valve state determiner 214 to control the switchings of the valve devices 120 via the respective drive circuits 204 and controls a linear motor controller 216 to control the linear motor 192 via the drive circuit 206. The linear motor controller 216 commands a target position of the linear motor 192, and the drive circuit 206 supplies, to the linear motor 192, current that is required for coincidence of the commanded target position with a position indicated by the encoder 208. As will be described below, the linear motor controller 216 also commands a target motive force to be produced by the linear motor 192, and the drive circuit 206 controls current to be supplied to the linear motor 192, for coincidence of the commanded target motive force with a reaction force indicated by the load cell 210.

As described above, the linear motor 192 is common among the six suction nozzles 60, while the six valve devices 120, the six drive circuits 204, and the six pressure sensors 126 are provided respectively for the six suction nozzles 60. However, Fig. 4 illustrates one valve device 120, one drive circuit 204, and one pressure sensor 126. Thus, these valve device 120, drive circuit 204, and pressure sensor 126 should be understood as those corresponding to one of the suction nozzles 60 which has been positioned at the component receiving/mounting position.

The present mounting head 30 is moved by the head moving device 32 along a horizontal XY plane to positions over the respective tape feeders 14 and a position over the board holding device 26. During this movement, the suction nozzle 60 is urged by the spring 84 and thereby held in contact with the mating member 82, that is, the nozzle 60 is kept located at a retracted position as an elevated position. It is noted that this machine can be configured such that, in addition to the above-described movement, the mounting head 30 is elevated and lowered in a Z direction perpendicular to the XY plane and uses the suction nozzle 60 to pick up a component 220 (see Fig. 3) from the tape feeder 14 by suction and mount the component 220 onto the board 22. In the present embodiment, however, the elevating and lowering motor 164 rotates the feed screw 166 to lower the elevating and lowering member 162 of the first elevating and lowering device 160, so that the rotatable up/down shaft 54 and the linear motor 192 is lowered, during which the linear motor 192 lowers the suction nozzle 60 relative to the rotatable up/down shaft 54. This configuration eliminates the need for elevating and lowering the mounting head 30. Also, the nozzle rotating motor 154 is operated as needed to correct or change a rotational position of the component 220 held by the suction nozzle 60. After the sucking and pressing of the component 220 on the board 22, the linear motor 192 and the spring 84 elevates the suction nozzle 60 relative to the rotatable up/down shaft 54, and the elevating and lowering member 162 of the first elevating and lowering device 160 is elevated, so that the rotatable up/down shaft 54 is elevated by the urging of the compression coil spring 172. It is noted that, in the present embodiment, a distance for which the first elevating and lowering device 160 lowers the rotatable up/down shaft 54 is fixed regardless of the thickness of the component 220 but may be changed according to the thickness of the component 220. For example, the greater the thickness of the component 220, the shorter the distance may be determined.

When the component is sucked, the valve device 120 is switched from the atmospheric open state to the negative-pressure supply state to supply the negative pressure to the suction nozzle 60. When the component is mounted, the valve device 120 is switched from the negative-pressure supply state to the positive-pressure supply state. That is, the suction nozzle 60 is isolated from the negative-pressure supply source 122 and fluidically coupled with the positive-pressure supply source 124, causing vacuum break that speedily eliminates negative pressure. As a result, the component 220 held by the suction nozzle 60 is released speedily and reliably. After the pressing of the component 220 on the board 22, the valve device 120 is switched from the positive-pressure supply state to the atmospheric open state, preventing leakage of positive pressure from the suction nozzle 60 that had mounted the component 220 and is now not holding the component 220. In the above-described operations, the same control as executed for a common mounting head is executed for control for the devices such as the first elevating and lowering device 160 and the nozzle rotating motor 154, and an explanation thereof is omitted. In the following description, there will be explained control different from the control in common mounting head. That is, control for the linear motor 192, specifically, control thereof in mounting of the component will be explained.

Some cases require high accuracy of controlling the pressing force when the component 220 held by the suction nozzle 60 is mounted on the board 22. These cases include: a case where the component 220 is relatively weak and liable to be damaged under excessive pressing force; and a case where a large pressing force causes solder cream to spread and come into contact with adjacent solder cream or become too thin to function properly as described in JP-A-2006-156443. Other examples of the cases include: a case where a substrate such as the board 22 on which the component 220 is mounted may be damaged or plastically deformed; and a case where, even if the deformation of the substrate is elastic deformation, this elastic deformation causes a positional error between the component 220 and the substrate in a direction intersecting a direction of the upward and downward movements of the suction nozzle 60. The following explanation will be provided with the above-described case, by way of example, where the control for the pressing force is executed in order to avoid damages to the component. Causes of excessive pressing force include: an impact when the component 220 is brought into contact with the board 22 (hereinafter referred to as "contacting impact"); and an increase in a force applied to the suction nozzle 60 and the component 220 upon the vacuum break in a forward direction (i.e., a down direction or a direction toward the board 22).

Control for reducing the contacting impact is described in the specification of PCT Patent Application No. PCT/JP2012/080163 and will be briefly explained.

When the suction nozzle 60 is lowered, the first elevating and lowering device 160 lowers the rotatable up/down shaft 54 and the linear motor 192, and simultaneously the linear motor 192 is activated, so that the second engaging portion 194 is engaged with the flange 196 of the suction nozzle 60 to lower the suction nozzle 60 against the urging force of the spring 84. Before the component 220 is brought into contact with the board 22, the suction nozzle 60 is moved away from the lower end face 112 as the stopper for a predetermined distance (that is a distance corresponding to the command of the target position). Within a travel period in Fig. 5, the suction nozzle 60 is kept lowered in this state together with the rotatable up/down shaft 54. A reaction force applied to the linear motor 192 within the travel period is indicated by the two-dot chain line.

Then, the component 220 held by the suction nozzle 60 is brought into contact with the board 22. In the present embodiment, the control system 200 including the drive circuit 206 is a system capable of executing high-frequency control, that is, the control system 200 is a high-frequency control system capable of executing a control cycle of at least two cycles before the reaction force applied to the linear motor 192 abruptly increases due to the above-described contact, and then a contact force becomes excessive after exceeding an permissible contact force. Once the above-described contact is detected by the load cell 210, the control system 200 controls the current supplied to the linear motor 192 such that the reaction force is equal to the sum of the reaction force within the travel period and a reaction force corresponding to a predetermined appropriate pressing force (indicated by I in Fig. 5) having appropriate magnitude. The appropriate pressing force is set for pressing the component 220 against the board 22 with enough strength without causing any damages. As a result of this control for the current supplied to the linear motor 192, the reaction force applied to the linear motor 192 is prevented from fluctuating as indicated by the two-dot chain line in Fig. 5 and stabilized as indicated by the solid line in Fig. 5 such that the contacting impact causes no damages to the component 220 and other elements.

After a length of time required for reducing the fluctuation of the reaction force to a small value passes from the start of the control for reducing the contacting impact, or at the time when an amount of the fluctuation of the reaction force is actually reduced to a value equal to or lower than a predetermined value, a signal is supplied from the linear motor controller 216 to inform the valve state determiner 214 about completion of the control for reducing the contacting impact. Then, after the vacuum break is caused by the valve state determiner 214, that is, after the valve device 120 is switched from the negative-pressure supply state to the positive-pressure supply state for a short length of time by the valve state determiner 214, the control for establishing the atmosphere communicating state is determined to be executed, and the valve device 120 is controlled via the drive circuit 204. The vacuum break changes the pressure in the mating portion 98 from the negative pressure to the positive pressure, resulting in increase in the pressure. Increment of the pressure acts on the suction nozzle 60 and the component 220 sucked by the suction nozzle 60. The suction nozzle 60 receives a forward-directional force that is obtained by the multiplication product of: an area of an upper face of a portion of the flange member 86 which corresponds to the shaft portion 80, i.e., an area of an annular pressure receiving surface of the portion of the flange member 86 which surrounds the negative pressure/positive pressure passage 102; and pressure increment in the mating portion 98 due to the vacuum break (i.e., a sum of an absolute value of a negative pressure value and a positive pressure value). This force will be referred to as "vacuum-break-caused nozzle advancing force". Also, the component 220 is acted by a force in a direction in which the component 220 is pressed and released from the suction nozzle 60. This force is obtained by the multiplication product of an area of a round pressure receiving surface of the component 220 which faces the negative pressure/positive pressure passage 102; and a positive pressure value in the mating portion 98. This force will be referred to as "vacuum-break-caused component release force". In view of the above, the component 220 receives not only the pressing force caused by the operation of the linear motor 192 but also a vacuum-break-caused acting force, as a force that increases the pressing force, which is the sum of the vacuum-break-caused nozzle advancing force and the vacuum-break-caused component release force. As a result, as indicated by II in Fig. 5, the pressing force with which the component 220 is pressed on the board 22 increases toward a value greater than the appropriate pressing force.

Accordingly, the current supplied to the linear motor 192 is controlled such that the component 220 is pressed against the board 22 with the appropriate pressing force even when the vacuum break occurs. After the start of the vacuum break, the pressure in the mating portion 98 rises and the vacuum-break-caused acting force increases. In the present embodiment, however, the increase in the vacuum-break-caused acting force is calculated by the linear motor controller 216 based on the pressure in the mating portion 98 which is detected by the pressure sensor 126, and a target motive force reduced accordingly and indicated by III in Fig. 5 is supplied from the linear motor controller 216 to the drive circuit 206. The drive circuit 206 controls the current supplied to the linear motor 192, such that the reduced target motive force coincides with the reaction force indicated by the load cell 210. As a result, the force produced by the operation of the linear motor 192 to press the component 220 against the board 22, i.e., the force that advances the suction nozzle 60 is reduced from the appropriate pressing force by the vacuum-break-caused acting force. Therefore, even when the vacuum break occurs, the component 220 is pressed against the board 22 with the appropriate pressing force indicated by IV in Fig. 5, avoiding damages to the component 220 due to the excessive pressing force.

It is noted that the control for reducing the force that advances the suction nozzle 60, from the appropriate pressing force by the vacuum-break-caused acting force only needs to be executed while the vacuum-break-caused acting force is acting, and thereafter the force that advances the suction nozzle 60 only needs to be avoided from becoming equal to or larger than the appropriate pressing force. This is for the following reason: since the suction of the component 220 by the suction nozzle 60 is released due to the vacuum break, and the component 220 has been once pressed on the board 22 with the appropriate pressing force, there is no need to increase the pressing force again, whereby the pressing force may of course be made smaller than the appropriate pressing force and may be eliminated. More specifically, the control for reducing the force that advances the suction nozzle 60, from the appropriate pressing force by the vacuum-break-caused acting force may be continued until the completion of implementation of the vacuum break (i.e., until the pressure in the mating portion 98 is lowered to the atmospheric pressure after the valve device 120 is switched from the positive-pressure supply state to the atmospheric open state) and may be continued until a start of the backward movement of the suction nozzle 60. Moreover, any of the completion of implementation of the vacuum break and the start of the backward movement of the suction nozzle 60 may come earlier in the control, and the control for making the pressing force smaller than the appropriate pressing force or eliminating the pressing force may be executed earlier than the the completion of implementation of the vacuum break and the start of the backward movement of the suction nozzle 60.

Also, the contacting impact is generated also when the suction nozzle 60 is brought into contact with the component 220 to pick up the component 220 from the tape feeder 14. Thus, as in the mounting, the control for reducing the contacting impact is executed in the suction of the component, but this explanation is omitted.

It will be understood from the foregoing explanation that, in the present embodiment, the linear motor 192 constitutes, together with the spring 84, a nozzle advancing device configured to move the suction nozzle 60 forward with respect to the mating member 82. It is noted that since the own weight of the suction nozzle 60 also applies a forward directional force to the suction nozzle 60, it is possible to consider that the suction nozzle 60 itself is a constituent element of the nozzle advancing device, but this weight of the suction nozzle 60 can be neglected in a case where this weight and the magnitude of the appropriate pressing force have a certain relationship. Also, the valve state determiner 214 and the linear motor controller 216 of the controller 202 which respectively control the valve devices 120 and the linear motor 192 constitute a control device. A portion of the controller 202 which controls the valve device 120 to cause the vacuum break constitutes a vacuum breaker as a negative pressure eliminator, and a portion of the controller 202 which calculates the increase of the vacuum-break-caused acting force based on the pressure obtained by the detection of the pressure sensor 126 constitutes the vacuum-break-caused-acting-force obtainer as a negative-pressure-elimination-caused-acting-force obtainer and constitutes a vacuum-break-caused-nozzle-advancing-force obtainer and a vacuum-break-caused-component-release-force obtainer, and these elements constitute a vacuum-break-caused-pressing-force-change obtainer. A portion of the controller 202 which changes the target motive force based on the increase of the obtained vacuum-break-caused acting force and commands the drive circuit 206 constitutes a vacuum-break-effect reducing actuator controller. The vacuum-break-caused-pressing-force-change obtainer and the vacuum-break-effect reducing actuator controller constitute, together with the pressure sensor, a vacuum break effect reducer as a negative-pressure-elimination-effect reducer.

The valve device may be switched from the negative-pressure supply state to the positive-pressure supply state before the component held by the suction nozzle is brought into contact with the substrate. For example, the switching may be performed such that the pressure in the suction nozzle is changed from the negative pressure to the positive pressure but does not rise to a vacuum-break predetermined positive pressure just before the component is brought into contact with the substrate. The pressure may be changed from the negative pressure to the positive pressure after the contact.

This machine may also be configured such that the valve device is switched from the negative-pressure supply state to the positive-pressure supply state before the component is brought into contact with the substrate and such that, when executing the control for reducing the vacuum-break-caused acting force, the target motive force produced by the linear motor 192 is temporarily reduced such that the maximum value of the pressing force due to the fluctuation of the pressing force which occurs even if the control for reducing the contacting impact is executed becomes greater than the appropriate pressing force.

It is noted that this control can of course be executed also in a case where the valve device is switched from the negative-pressure supply state to the positive-pressure supply state after the component held by the suction nozzle is brought into contact with the substrate.

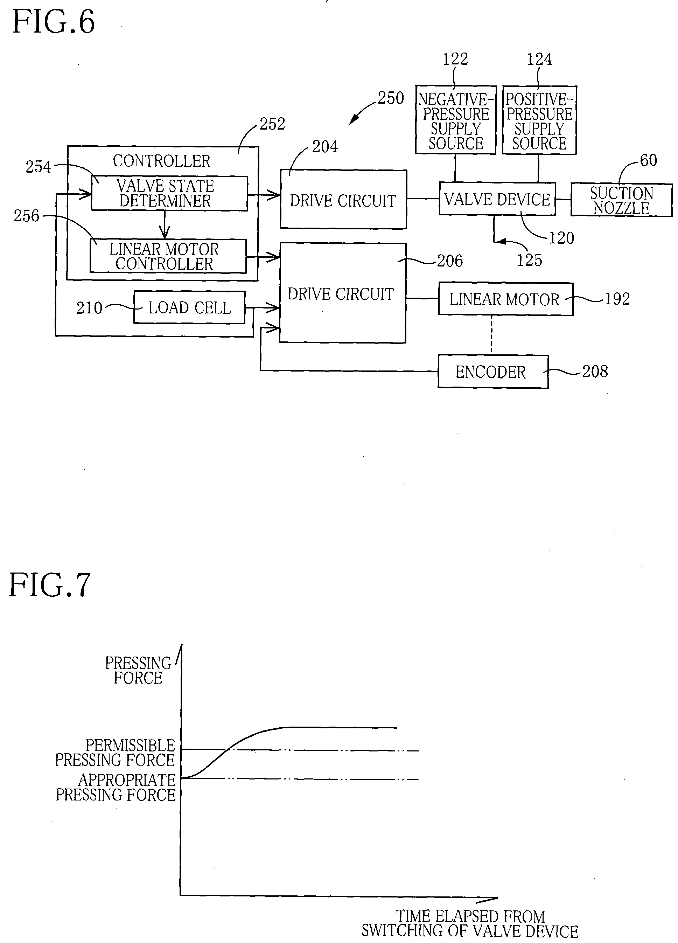

In the control for reducing the effect of the vacuum break, the actuator may be controlled based on a positive-pressure-supply start timing (a vacuum-break implementation start timing) itself. One example of this embodiment will be explained with reference to Figs. 6 and 7. It is noted that the same reference numerals as used in the above-described embodiment are used to designate the corresponding elements of this embodiment, and an explanation of which is dispensed with.

A control system 250 in the present embodiment includes a controller 252. The controller 252 includes a valve state determiner 254 configured to detect the end of the control for reducing the contacting impact based on the output of the load cell 210 and command the valve device 120 to start implementation of the vacuum break via the drive circuit 204, and at the same time, a valve switching signal is supplied to a linear motor controller 256. The linear motor controller 256, on the other hand, controls the linear motor 192 such that the pressing force with which the suction nozzle 60 presses the component 220 against the board 22 has become the appropriate pressing force before the supply of the valve switching signal. At a timing when a set length of time passes from the vacuum-break implementation start timing, control for reducing, to a predetermined magnitude, a component pressing force produced by the nozzle advancing device constituted by the linear motor 192 and the spring 84 is started to reduce the effect of the vacuum break.

The above-described set length of time and an amount of reduction of the force with which the component 220 is pressed against the board 22 are determined by experiments. A relationship, illustrated in Fig. 7, between a pressing force and an elapsed time after the switching of the valve device 120 from the negative-pressure supply state to the positive-pressure supply state (i.e., from the start of the implementation of the vacuum break) is obtained in advance by experiments. This pressing force includes the vacuum-break-caused acting force, and a relationship between a length of time elapsed from the vacuum-break implementation start timing and the vacuum-break-caused acting force is obtained.

The experiments are carried out using a mounting head that has the same construction as the mounting head 30 actually used for the mounting of the component. Also, the experiment is carried out for each type of the suction nozzle 60. This is because different types of the suction nozzles 60 have different diameters of the suction face 106, causing variations of the diameter (i.e., the outside diameter) of the shaft portion 80 and variations of the diameter of the negative pressure/positive pressure passage 102, resulting in variations of the vacuum-break-caused acting force. The target motive force produced by the linear motor 192 is kept constant in a state in which the appropriate pressing force is obtained after the suction nozzle 60 holding the component 220 is lowered and brought into contact with a force detection sensor, while the valve device 120 is switched from the negative-pressure supply state to the positive-pressure supply state, and the pressing force including the vacuum-break-caused acting force is detected.

The set length of time, for example, is set so as to end at a timing between the timing when the pressure starts to rise and the timing when the pressing force reaches the permissible pressing force, after the supply of the valve switching signal. Here, the permissible pressing force is assumed to be set on condition that the force does not break the component 220. In a case where the appropriate pressing force is also the permissible pressing force, this machine only needs to be configured such that the linear motor controller 256 controls the pressing force to be a value smaller than the appropriate pressing force by a fixed value until the above-described valve switching signal is supplied, and such that the above-described set length of time is set at a length of time between the timing when the pressure starts to rise and the timing when the pressing force reaches the appropriate pressing force.

For example, the amount of reduction is set so as to reduce all the increment of the pressing force due to the vacuum-break-caused acting force, and the target motive force produced by the linear motor 192 is set at a magnitude required for the reduction, so that the amount of reduction and the target motive force are stored into the linear motor controller 256 together with the set length of time. At the timing when the set length of time has passed after the linear motor controller 256 obtains the valve switching signal supplied from the valve state determiner 254, the linear motor controller 256 outputs the set target motive force to the drive circuit 206 to start control for reducing the pressing force caused by the operation of the linear motor 192.

In the present embodiment, a vacuum-break-implementation-start-timing obtainer is constituted by a portion of the linear motor controller 256 which obtains the valve switching signal from the valve state determiner 254, a vacuum-break-implementation-start-timing-dependent actuator controller is constituted by a portion of the linear motor controller 256 which changes the target motive force produced by the linear motor 192 to reduce the motive force produced by the linear motor 192 after the set length of time passes after the start of the implement of the vacuum break, and these elements constitute a vacuum break effect reducer.

The above-described set length of time and the amount of reduction of the component pressing force produced by the nozzle advancing device can be determined logically. That is, the vacuum-break-caused acting force after the start of the implementation of the vacuum break can be estimated logically, without use of experiments, based on the diameters and lengths of the negative pressure/positive pressure passages 100, 102, the inside diameter of the mating hole 70, the negative pressure in the suction nozzle 60, the area of the pressure receiving surface for receiving the positive pressure, and the structure of the valve device 120, for example. The set length of time and the above-described amount of reduction are determined based on this estimation. The pressure in the suction nozzle can be estimated separately from the pressure in the mating portion but can be considered to be equal to the pressure in the mating portion.

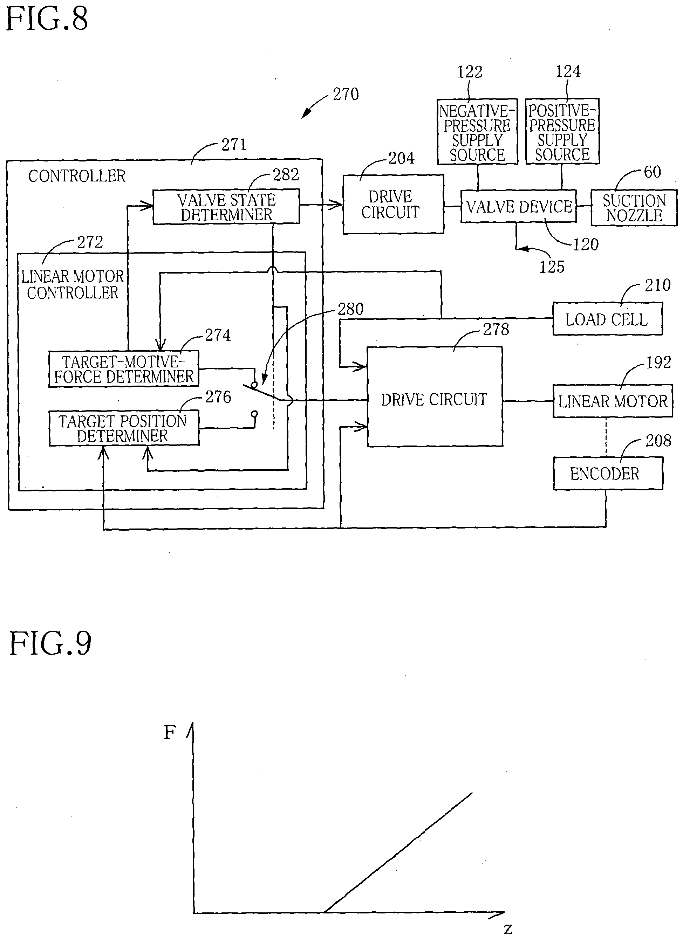

The control for reducing the effect of the vacuum break may be executed utilizing switching from the control for the motive force produced by the linear motor 192 to control for a position of the linear motor 192. One example of this embodiment will be explained with reference to Figs. 8 and 9. It is noted that the mechanical structure of the mounting machine is the same as that of the mounting machine according to the embodiment illustrated in Figs. 1-5, for example.

As illustrated in Fig. 8, a control system 270 in the present embodiment includes a controller 271. A linear motor controller 272 of this controller 271 includes a target-motive-force determiner 274 and a target position determiner 276 independently of each other. The target-motive-force determiner 274 is configured to determine the target motive force to be produced by the linear motor 192, and the target position determiner 276 is configured to determine the target position of the linear motor 192. The control system 270 includes a switching circuit 280 configured to switch a connection to a drive circuit 278 for driving the linear motor 192, between the target-motive-force determiner 274 and the target position determiner 276.

Fig. 9 conceptually illustrates a relationship between a displacement z of the suction nozzle 60 being lowered and a reaction force F applied to the suction nozzle 60. As illustrated in this figure, before the component 220 is brought into contact with the board 22, the reaction force F is zero even if the displacement z changes, and after the contact, the reaction force F changes with a change of the displacement z. The inclination of this change is determined largely by an elastic coefficient c of the board 22. It is noted that, even in a case where the substrate in the form of the circuit board having a planar plate shape is close to being rigid, the substrate can in reality be elastically deformed slightly. Also, even in the case of the same circuit board of the planar plate shape, the circuit board can be elastically deformed considerably depending upon how a back surface of the circuit board is supported, that is, some substrate has an elastically deformable shape. In both cases, an amount of elastic deformation of the substrate can normally be considered to be changed linearly in proportion to increase in the pressing force, and accordingly it is assumed that only the value of the elastic coefficient c changes the inclination of the straight line indicating the relationship.

Since the switching circuit 280 is usually in its state in which the target-motive-force determiner 274 and the drive circuit 278 are connected to each other, the command of the target motive force (i.e., the sum of the appropriate pressing force and the reaction force applied to the linear motor 192 in the travel period) is supplied to the drive circuit 278. Thus, the drive circuit 278 is operated to cause the linear motor 192 to lower the suction nozzle 60 until the motive force produced by the linear motor 192 becomes equal to the target motive force, that is, until the force indicated by the output of the load cell 210 which is the sum of the pressing force with which the component 220 held by the suction nozzle 60 is pressed against the board 22 and the reaction force applied to the linear motor 192 in the travel period becomes equal to the target motive force.

When the component 220 held by the suction nozzle 60 is brought into contact with the board 22 and pressed against the board 22 with the appropriate pressing force, this fact is detected by the target-motive-force determiner 274 based on the output of the load cell 210, and the target-motive-force determiner 274 supplies a signal to a valve state determiner 282. The valve state determiner 282 then commands the switching of the switching circuit 280, and the switching circuit 280 switches the connecting state from the state in which the target-motive-force determiner 274 is connected to the drive circuit 278 to the state in which the target position determiner 276 is connected to the drive circuit 278. The valve device 120 is then commanded via the drive circuit 204 to perform the switching from the negative-pressure supply state to the positive-pressure supply state, that is, the start of the implementation of the vacuum break is commanded. The target position determiner 276 receives the output of the encoder 208 also before the switching of the switching circuit 280. Based on the switching command supplied from the valve state determiner 282 to the switching circuit 280, the target position determiner 276 keeps the output of the encoder 208 supplied at the instant of the switching, then determines a position corresponding to the output as the target position, and continues commanding.

Upon the start of the implementation of the vacuum break, the vacuum-break-caused nozzle advancing force is applied to the suction nozzle 60, the vacuum-break-caused component release force is applied to the component 220, and the pressing force with which the component 220 is pressed against the board 22 is to increase due to the increase in the vacuum-break-caused acting force that is the sum of the vacuum-break-caused nozzle advancing force and the vacuum-break-caused component release force. In the present embodiment, however, the target-motive-force determiner 274 is disconnected from the drive circuit 278, and the target position determiner 276 continues to command the fixed target position. Accordingly, the drive circuit 278 reduces drive current by an amount corresponding to the vacuum-break-caused nozzle advancing force to keep the linear motor 192 at the fixed position, so that the pressing force with which the component 220 is pressed against the board 22 increases by only the vacuum-break-caused component release force.

It will be understood from the foregoing explanation that, in the present embodiment, the target-motive-force determiner 274, the drive circuit 278, and the load cell 210 constitute a force controller, and the target position determiner 276, the drive circuit 278, and the encoder 208 constitute a position controller. Also, the switching circuit 280 constitutes a controller switcher together with a portion of the target position determiner 276 which keeps the output of the encoder 208 supplied at the instant of the switching, then determines the position corresponding to the output as the target position, and continues commanding. Also, the valve state determiner 282 constitutes, together with the drive circuit 204, a switching-timing-dependent valve controller configured to switch the valve device 120 after the controller switcher switches the controller from the force controller to the position controller.

It is noted that, in a case where the pressing force with which the component is pressed against the board needs to be changed to the target value more accurately, feedforward control is preferably used in addition to the feedback control in each of the above-described embodiments. When the valve device 120 is switched from the negative-pressure supply state to the positive-pressure supply state, the pressing force with which the component is pressed against the substrate inevitably increases, and a magnitude and a timing of this increase can be estimated. Thus, the feedforward control for eliminating at least a portion of the increase in the pressing force can be executed for the nozzle advancing device (i.e., the linear motor 192). Consequently, when compared with a case where only the feedback control is used, it is possible to reliably reduce undesirable fluctuations of the pressing force due to the implementation of the vacuum break.

Also, the use of the feedforward control with the feedback control is not essential, and the use of the feedforward control alone also exhibits the effects.

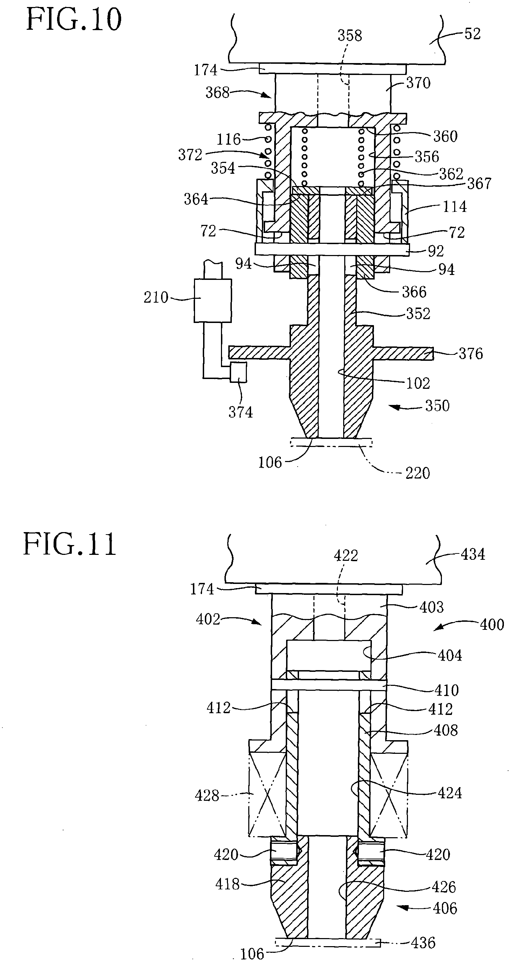

This machine may be configured such that a stopper is provided between the nozzle holder and the suction nozzle to define an advancing limit, i.e., a forward movement limit of the suction nozzle with respect to the nozzle holder, and an urging member is provided for urging the suction nozzle with respect to the nozzle holder toward the stopper. Fig. 10 illustrates one example of this embodiment.

In the present embodiment, a compression coil spring 362 (hereinafter referred to simply as "spring 362") is provided between a flange member 354 and a stepped face 360 and urges a suction nozzle 350 in the forward direction. The flange member 354 is fixed to a shaft portion 352 of the suction nozzle 350, and the stepped face 360 is located between a mating hole 356 and a negative pressure/positive pressure passage 358. The advancing limit to which an urging force of the spring 362 can advance the suction nozzle 350 is defined by contact of a lower end face 364 of the flange member 354 with an upper end face 367 of a mating member 366 that is fitted on the shaft portion 352 so as to be movable relative to the shaft portion 352 in its axial direction. In the present embodiment, the upper end face 367 of the mating member 366 constitutes the stopper, and a lower end portion of an up/down-shaft main body 370 of a rotatable up/down shaft 368 and the mating member 366 constitutes the nozzle holder and constitutes, together with the shaft portion 352 of the suction nozzle 350, a mating portion 372 for the nozzle holder and the suction nozzle. Also, in a state in which the elevating and lowering member 162 of the first elevating and lowering device 160 is located at its upper end position, and the rotatable up/down shaft 368 is located at its upper limit position, a second engaging portion 374 of the linear motor 192 is moved to a position slightly spaced apart from a lower surface of a flange 376 of the suction nozzle 350, allowing rotation and revolution of the suction nozzle 350. The linear motor 192 and the spring 362 constitute the nozzle advancing device. The other constructions are the same as those in the embodiment illustrated in Figs. 1-5, and the same reference numerals as used in the above-described embodiment are used to designate the corresponding elements of this embodiment, and an explanation of which is dispensed with.

In the present embodiment, when the suction nozzle 350 at the component receiving/mounting position is lowered by the first elevating and lowering device 160, the linear motor 192 is activated before the component 220 is brought into contact with the board 22, and the suction nozzle 350 is retracted against the urging force of the spring 362 to move the flange member 354 away from the mating member 366 for a predetermined distance. The component 220 is bought into contact with the board 22 during the downward movement of the linear motor 192 supporting the suction nozzle 60 from a lower side thereof, whereby a reaction force applied to the linear motor 192 is to become smaller sharply. This change is detected by the load cell 210, and drive current supplied to the linear motor 192 is increased to reduce the contacting impact.

After the component 220 is brought into contact with the board 22, the valve device 120 is switched from the negative-pressure supply state to the positive-pressure supply state to implement the vacuum break in the suction nozzle 350. In the present embodiment, as in the embodiment illustrated in Figs. 1-5, for example, after the start of the implementation of the vacuum break, pressure in the mating portion 372 is detected by the pressure sensor 126, and the linear motor 192 is controlled based on the detected pressure, whereby the increase in the pressing force due to the vacuum break is eliminated by reduction of a force directed in the nozzle advance direction and produced by the nozzle advancing device (i.e., increase in the motive force produced by the linear motor 192), thereby suppressing the increase in the pressing force.

Alternatively, as in the embodiment illustrated in Figs. 6 and 7, the predetermined target motive force is supplied to the linear motor controller after the set length of time passes from the switching of the valve device 120. However, since the suction nozzle 350 is urged in the forward direction with respect to the nozzle holder, and the linear motor 192 supports the suction nozzle 350 from below, the target motive force is set at a magnitude that is larger than a magnitude in which the pressing force produced by the linear motor 192 corresponds to the appropriate pressing force, by the increment of the pressing force due to the vacuum-break-caused acting force.

The urging member for urging the suction nozzle with respect to the nozzle holder may be omitted. One example of this embodiment will be explained with reference to Fig. 11.

A mounting head 400 according to the present embodiment includes a plurality of rotatable up/down shafts 402 (one of which is illustrated in Fig. 11). In each of the rotatable up/down shafts 402, a shaft portion 408 of a suction nozzle 406 is fitted in a mating hole 404 formed in a lower end portion of an up/down-shaft main body 403 so as to be movable relative to the mating hole 404 in an axial direction of the shaft portion 408. A pin 410 is provided extending through the up/down-shaft main body 403 and the shaft portion 408 in their diameter direction. The pin 410 is secured to the rotatable up/down shaft 402 so as to extend through a pair of elongate holes 412 each elongated in the axial direction of the shaft portion 408, and the pin 410 is slidable in the pair of elongate holes 412. The rotatable up/down shaft 402 constitutes the nozzle holder. The suction nozzle 406 can be moved relative to the rotatable up/down shaft 402 in its axial direction. Also, the suction nozzle 406 cannot be rotated relative to the rotatable up/down shaft 402 but can be rotated together with the rotatable up/down shaft 402.

The shaft portion 408 holds a suction portion 418 of the suction nozzle 406. The suction portion 418 is removably mounted on the shaft portion 408 by ball plungers 420 as one kind of an engaging member. Negative pressure or positive pressure is supplied to a negative pressure/positive pressure passage 424 formed in the shaft portion 408 and a negative pressure/positive pressure passage 426 formed in the suction portion 418, via a negative pressure/positive pressure passage 422 and the mating hole 404 which are formed in the rotatable up/down shaft 402. Provided between the rotatable up/down shaft 402 and the shaft portion 408 is a linear motor 428 that constitutes a second elevating and lowering device. Though not illustrated in detail, the linear motor 428 includes: a fixed portion held by the rotatable up/down shaft 402 immovably and not rotatably relative to the rotatable up/down shaft 402 in the axial direction; and a movable portion movable relative to the fixed portion in the axial direction, and the movable portion is secured to the suction nozzle 406. The linear motors 428 are provided respectively for the plurality of suction nozzles 406, the suction nozzles 406 are individually elevated and lowered by the respective linear motors 428 with respect to the respective rotatable up/down shafts 402.

Rotation of a rotary body 434 revolves the plurality of rotatable up/down shafts 402 such that one of them is positioned at the component receiving/mounting position. When the shaft 402 is revolved to the component receiving/mounting position, negative pressure is supplied to the suction nozzle 406, and an upward force is applied to the rotatable up/down shaft 402 based on the negative pressure. In the suction nozzle 406, however, the upper end faces of the elongate holes 412 are held in contact with the pin 410 by the sum of the own weight of the suction nozzle 406 (it is assumed that the weight of a component 436 can be neglected) and the downward motive force of the linear motor 428. The rotatable up/down shaft 402 is lowered at the component receiving/mounting position by a first elevating and lowering device, not shown, that is common for the plurality of suction nozzles 406, and thereby the suction nozzle 406 is lowered. When the component 436 is brought into contact with the board, the suction nozzle 406 is moved upward with respect to the rotatable up/down shaft 402. In this movement, the downward movement of the rotatable up/down shaft 402 by the first elevating and lowering device is smoothly accelerated to prevent the suction nozzle 406 from floating up from the pin 410. Also, just before the component 436 is brought into contact with the board, the downward movement of the rotatable up/down shaft 402 is smoothly decelerated to prevent the component 436 from contacting the board by an impact force greater than a set value.

In the present embodiment, after the contact of the component 436, the valve device is switched from the negative-pressure supply state to the positive-pressure supply state to implement the vacuum break. As a result, the force acting on the suction nozzle 406 and the component 436 increases by the vacuum-break-caused acting force that is equal to the multiplication product of the area of the circle defined by the outside diameter of the shaft portion 408; and the increment of the pressure in the mating hole 404 due to the switching from the negative-pressure supply state to the positive-pressure supply state (i.e., the implementation of the vacuum break). This increment is calculated before the contact of the component 436 with the board, and the control for the linear motor 428 is changed depending upon whether a vacuum-break pressing force that is the sum of the motive force of the linear motor 428 which is applied before the contact of the component 436 and the weight of the suction nozzle 406 is larger or smaller than the appropriate pressing force with which the component 436 is pressed on the board. In a case where the vacuum-break pressing force is larger than the appropriate pressing force, the motive force of the linear motor 428 is reduced by an excess amount before the vacuum-break pressing force becomes equal to or larger than the appropriate pressing force at the latest. In a case where the vacuum-break pressing force is smaller than the appropriate pressing force, the motive force of the linear motor 428 is increased by an amount corresponding to the shortage.

It is noted that, in the latter case, the motive force of the linear motor 428 may be increased before or after the switching to the positive-pressure supply state. In the former case, if the pressing force of the component 436 against the board is still excessive after the reduction in the motive force of the linear motor 428, the motive force of the linear motor 428 can be changed in a direction in which the suction nozzle 406 is moved backward. In this case, however, the motive force of the linear motor 428 needs to be controlled so as to eliminate at least a portion of the increase in the pressing force due to the vacuum break, but the component 436 pressed against the board is not moved off the board. Thus, it is preferable that the pressure sensor detects the pressure in the mating portion between the rotatable up/down shaft 402 and the suction nozzle 406, or that a relationship between a length of time elapsed from the supply of the switching command to the valve device and the pressure in the above-described mating portion is estimated.

In the present embodiment, the nozzle advancing device is constituted by the linear motor 428 alone or in combination with the suction nozzle 406 (its own weight).

The multiplication product of the area of the circle defined by the outside diameter of the shaft portion 408; and the increment of the pressure in the mating hole 404 due to the implementation of the vacuum break is the vacuum-break-caused acting force that is the sum of: the vacuum-break-caused nozzle advancing force that is the multiplication product of the area of the pressure receiving surface of the suction nozzle which receives the pressure in the mating portion in the forward direction and the pressure increment in the mating portion; and the vacuum-break-caused component release force that releases the electronic component from the suction nozzle due to the pressure increase in the suction nozzle. A portion of the control device which obtains the vacuum-break-caused acting force constitutes the vacuum-break-caused-acting-force obtainer and constitutes the vacuum-break-caused-nozzle-advancing-force obtainer and the vacuum-break-caused-component-release-force obtainer.

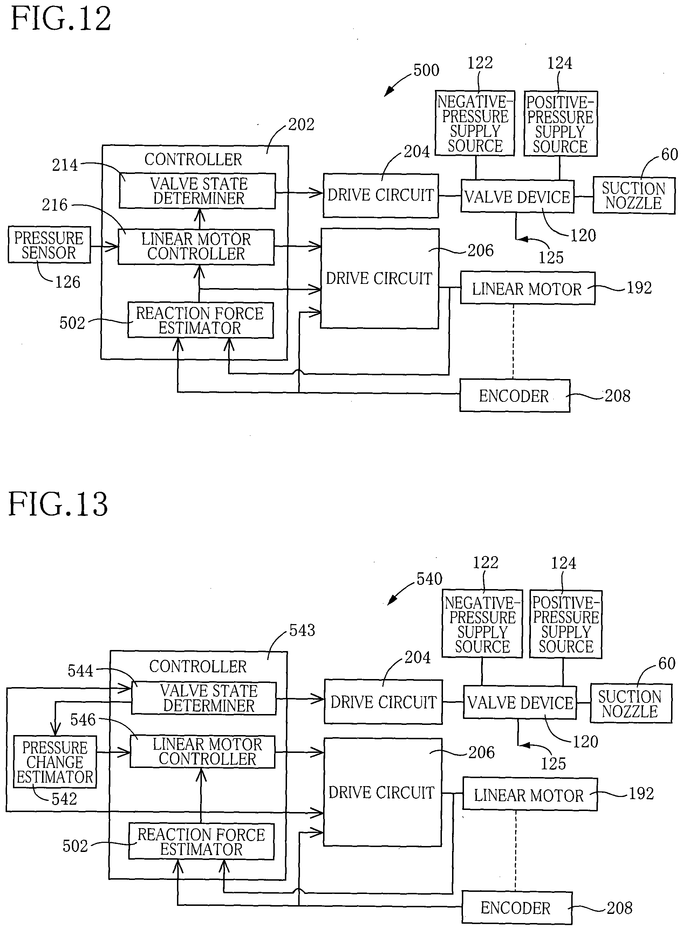

There will be next explained another embodiment of the present invention with reference to Fig. 12. It is noted that the mechanical structure of the mounting machine is the same as that of the mounting machine according to the embodiment illustrated in Figs. 1-5 except that the load cell is not provided. In a control system 500 in the present embodiment, a reaction force estimator 502 is provided instead of the load cell 210. Information supplied to the reaction force estimator 502 include: information about the drive current supplied from the drive circuit 206 to the linear motor 192; and information about the position of the linear motor 192 which is detected by the encoder 208. The reaction force estimator 502 estimates the reaction force applied to the linear motor 192, based on information about the drive current and the position, and supplies the estimated reaction force to the linear motor controller 216. The present embodiment is the same as the embodiment illustrated in Figs. 1 -5 except that this estimated reaction force is used instead of the output of the load cell 210, and a detailed explanation is dispensed with.

Fig. 13 illustrates yet another embodiment of the present invention. The present embodiment is different from the embodiment illustrated in Fig. 6 in that a value of estimated pressure in the mating portion 98 is supplied from a pressure change estimator 542 instead that the positive-pressure-supply start timing is supplied from the valve state determiner 254 to the linear motor controller 256, and that the reaction force estimator 502 is provided instead of the load cell 210. Since the reaction force estimator 502 is the same as that in the embodiment illustrated in Fig. 12, an explanation thereof is dispensed with, and the pressure change estimator 542 will be explained.

In a control system 540 in the present embodiment, data defining a relationship between pressure and an elapsed time after the switching of the valve device 120 from the negative-pressure supply state to the positive-pressure supply state is obtained in advance by experiments, and the relationship is set by a table or an arithmetic expression and stored as elapsed-time/pressure defined data into the pressure change estimator 542. The pressure change estimator 542 receives the valve switching signal from a valve state determiner 544 of a controller 543 and obtains a pressure value from the elapsed-time/pressure defined data and the elapsed time after the supply of the valve switching signal to supply the pressure value as the estimated pressure value to a linear motor controller 546. The linear motor controller 546 controls the linear motor 192 such that the pressing force with which the suction nozzle 60 presses the component 220 against the board 22 becomes the appropriate pressing force by the time when the estimated pressure value is supplied. The linear motor controller 546 determines, as the target motive force, a motive force obtained by subtracting, from the motive force produced by the linear motor 192 at the time, a magnitude corresponding to the estimated pressure value supplied from the pressure change estimator 542 and outputs the determined motive force to the drive circuit 206. The drive circuit 206 accordingly reduces the drive current to be supplied to the linear motor 192, by a magnitude corresponding to the estimated pressure value supplied from the pressure change estimator 542. This operation makes it possible to avoid excess of the pressing force with which the suction nozzle 60 presses the component 220 against the board 22, regardless of the implementation of the vacuum break, so that the component 220 is kept pressed against the board 22 with the appropriate pressing force.

It is noted that the pressure change may be logically estimated to produce the elapsed-time/pressure defined data. Also, a vacuum-break-caused-acting-force estimator is provided instead of the pressure change estimator to obtain the vacuum-break-caused acting force after the switching of the valve. For example, a relationship between a pressing force and an elapsed time after switching of the valve is obtained logically or by experiments, then elapsed-time/vacuum-break-caused-acting-force defined data is produced and stored into the vacuum-break-caused-acting-force estimator, and after the supply of the valve switching signal, and a vacuum-break-caused acting force obtained depending upon the elapsed time is supplied to the linear motor controller. In this embodiment, a portion of the vacuum-break-caused-acting-force estimator which obtains the valve switching signal from the valve state determiner 544 constitutes the vacuum-break-implementation-start-timing obtainer, and the vacuum-break-caused-acting-force estimator constitutes a vacuum-break-caused-pressing-force-change estimator. These elements constitute the vacuum-break-caused-pressing-force-change obtainer.

This machine may execute the following operations: a relationship between the elapsed time from the switching of the valve device and the component pressing force produced by the nozzle advancing device are obtained logically or by experiments, then data is produced for defining a relationship between the elapsed time and the target motive force or a drive current value of the linear motor which is required for reducing at least a portion of the vacuum-break-caused acting force, and then the control for reducing the effect of the vacuum break is executed based on the data and the vacuum-break implementation start timing.

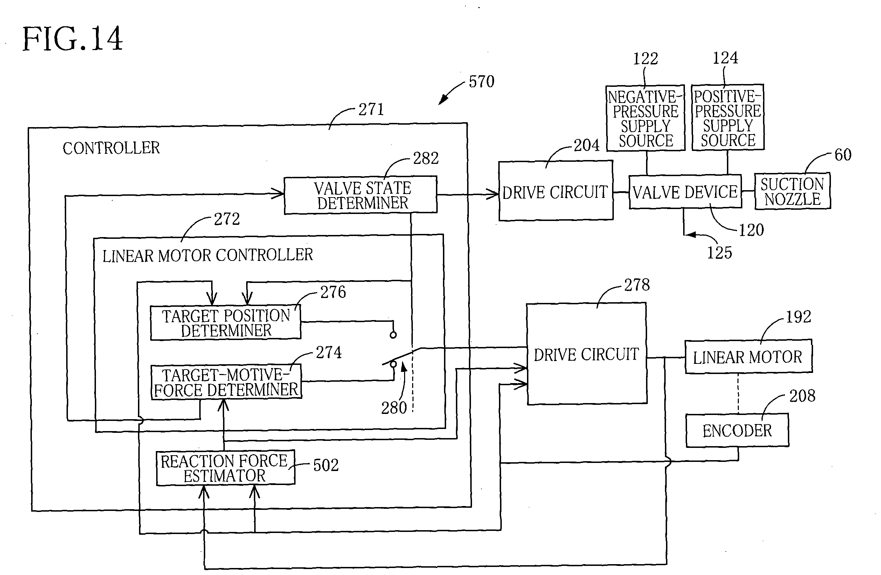

Fig. 14 illustrates yet another embodiment. A control system 570 in the present embodiment is the same as the control system illustrated in Fig. 8 except for providing the reaction force estimator 502 used in the embodiment illustrated in Fig. 12 instead of the load cell 210, and an explanation thereof is dispensed with.

Also, in the embodiment illustrated in Fig. 11, a nozzle holder may be provided independently of the rotatable up/down shaft 402 to hold the suction nozzle. For example, the rotatable up/down shaft holds the nozzle holder movably relative to the nozzle holder in the axial direction and not rotatably relative to the nozzle holder and holds the second elevating and lowering device immovably relative to the second elevating and lowering device in the axial direction, and the second elevating and lowering device holds the nozzle holder. In this state, the second elevating and lowering device is elevated and lowered relative to the rotatable up/down shaft to elevate and lower the suction nozzle. The second elevating and lowering device may or may not be rotated together with the rotatable up/down shaft.

The mounting head may have one suction nozzle as described in PCT Patent Application No. PCT/JP2012/080163, for example.

Also in the mounting head having one suction nozzle, the urging member may not be provided between the suction nozzle and the nozzle holder.

The suction nozzle may not be elevated and lowered by the first and second elevating and lowering devices in two steps and may be elevated and lowered by one elevating and lowering device.

The valve device may not have the atmospheric open state and may be switched selectively to one of the negative-pressure supply state and the positive-pressure supply state. In this case, where the mounting head have a plurality of the suction nozzles, it is preferable that the component is mounted on the substrate, and if the positive pressure leaks from an empty suction nozzle, the control for reducing the effect of the vacuum break is executed while taking the leak into consideration.

The positive-pressure supply source may be omitted. In this case, the valve device is configured to be selectively switched to one of the negative-pressure supply state and the atmospheric open state, and the component is released by a simple operation of connecting the suction nozzle to the atmosphere. This embodiment is also one example of the elimination of the negative pressure.

Furthermore, in a case where the effect of the vacuum break is reduced, all the effect is preferably reduced, but a part of the effect may be reduced. It is obvious that partial reduction of the effect is better than no reduction of the effect, especially in a case where the object can be achieved by partial reduction. One example of this case is the following: in a case where the object of reducing the effect of the vacuum break is to prevent breakage of the component, the appropriate pressing force is set for an object different from the prevention of the breakage of the component, and a permissible width of fluctuation of the appropriate pressing force is relatively large, only the partial reduction of the effect of the vacuum break can prevent the breakage of the component and can bring the appropriate pressing force within a permissible range.

### EXPLANATION OF REFERENCE NUMERALS

30: mounting head, 54: rotatable up/down shaft, 60: suction nozzle, 100, 102: negative pressure/positive pressure passage, 120: valve device, 122: negative-pressure supply source, 124: positive-pressure supply source, 126: pressure sensor, 160: first elevating and lowering device, 162: elevating and lowering member, 164: elevating and lowering motor, 190: second elevating and lowering device, 192: linear motor, 200: control system, 202: controller, 214: valve state determiner, 216: linear motor controller, 220: electronic component, 250: control system, 252: controller, 254: valve state determiner, 256: linear motor controller, 270: control system, 271: controller, 272: linear motor controller, 274: target-motive-force determiner, 276: target position determiner, 280: switching circuit, 282: valve state determiner, 350: suction nozzle, 358: negative pressure/positive pressure passage, 368: rotatable up/down shaft, 400: mounting head, 402: rotatable up/down shaft, 406: suction nozzle, 422, 424, 426: negative pressure/positive pressure passage, 428: linear motor, 436: electronic component, 500: control system, 502: reaction force estimator, 540: control system, 542: pressure change estimator, 543: controller, 544: valve state determiner, 546: linear motor controller, 570: control system

## Claims

1. Electronic-component mounting machine (10) comprising: a suction nozzle (60; 350; 406) configured to suck and hold an electronic component (220; 436) using negative pressure; and a nozzle advancing device comprising at least an actuator (84, 192), the electronic-component mounting machine being configured to: have the nozzle advancing device advance the suction nozzle holding the electronic component to press the electronic component against a substrate (22); and eliminate the negative pressure in the suction nozzle to release the electronic component and mount the electronic component on the substrate,
the electronic-component mounting machine further comprising:
a valve device (120) provided between (i) the suction nozzle and (ii) a negative-pressure supply source (122) configured to supply the negative pressure and a negative-pressure eliminating source (124, 125) configured to eliminate the negative pressure, the valve device being configured to control at least one of supply of the negative pressure to the suction nozzle and elimination of the negative pressure; and
a control device (202; 252; 271; 543) configured to control the valve device and the nozzle advancing device,
the control device comprising:
a negative pressure eliminator (214; 254; 282; 544) configured to control the valve device (120) to have the suction nozzle (60; 350; 406) release the electronic component (220; 436); and
an elimination effect reducer (216; 256; 272; 546) configured to control the nozzle advancing device to eliminate at least a portion of effect of the negative-pressure elimination caused by the negative pressure eliminator, on a pressing force with which the electronic component is pressed against the substrate.

2. Electronic-component mounting machine according to claim 1,
wherein the negative-pressure eliminating source comprises a positive-pressure supply source configured to supply positive pressure, and
wherein the elimination effect reducer comprises a vacuum break effect reducer configured to reduce at least a portion of effect of vacuum break that supplies the positive pressure to the suction nozzle to speedily eliminate the negative pressure.

3. Electronic-component mounting machine according to claim 1 or 2, wherein the elimination effect reducer comprises: a first actuator controller configured to reduce the effect of the negative-pressure elimination on the pressing force by incorporating, into a control for the actuator, at least one of: a negative-pressure-elimination-caused pressing force change leading to a change of the pressing force due to the negative-pressure elimination caused by the negative pressure eliminator; and an implementation start timing of the negative-pressure elimination.

4. Electronic-component mounting machine according to at least one of the preceding claims 1 to 3, wherein the elimination effect reducer (216; 256; 272; 546) comprises:
a pressing-force-change obtaining means configured to obtain a negative-pressure-elimination-caused pressing force change leading to a change of the pressing force of the electronic component on the substrate due to the negative-pressure elimination caused by the negative pressure eliminator; and
a first actuator controller configured to control the actuator to reduce a force that advances the suction nozzle (60; 350; 406) of the nozzle advancing device, by an amount corresponding to at least a portion of the negative-pressure-elimination-caused pressing force change obtained by the pressing-force-change obtaining means.

5. Electronic-component mounting machine according to at least one of the preceding claims 1 to 4, further comprising a nozzle holder (62, 82; 366, 370; 402) slidably fitted on the suction nozzle (60; 350; 406) and holding the suction nozzle (60; 350; 406) such that the nozzle holder (62, 82; 366, 370; 402) and the suction nozzle (60; 350; 406) are movable relative to each other in an axial direction of the nozzle holder (62, 82; 366, 370; 402), wherein at least the negative pressure is supplied from a side of the nozzle holder (62, 82; 366, 370; 402) to a side of the suction nozzle via a mating portion (98; 372) of the nozzle holder (62, 82; 366, 370; 402) and the suction nozzle (60; 350; 406).

6. Electronic-component mounting machine according to claim 5,
wherein a stopper (112; 366) and an urging member (84; 362) are provided between the nozzle holder (62, 82; 366, 370; 402) and the suction nozzle (60; 350; 406),
wherein the stopper (112; 366) is configured to define one of a retracting limit and an advancing limit of the suction nozzle (60; 350; 406) with respect to the nozzle holder (62, 82; 366, 370; 402), and the urging member is configured to urge the suction nozzle (60; 350; 406) with respect to the nozzle holder (62, 82; 366, 370; 402) toward the stopper (112; 366), and
wherein at least the urging member (84; 362) and the actuator (192) constitute the nozzle advancing device.

7. Electronic-component mounting machine according to claim 5 or 6,
wherein the elimination effect reducer comprises: a pressing-force-change obtaining means configured to obtain a negative-pressure-elimination-caused pressing force change leading to a change of the pressing force of the electronic component on the substrate due to the negative-pressure elimination, and
wherein the pressing-force-change obtaining means comprises:
a nozzle-advancing-force obtaining means configured to obtain a nozzle advancing force due to the elimination of the negative pressure, as a multiplication product of pressure increment in the mating portion and an area of a pressure receiving surface of the suction nozzle which receives the pressure in the mating portion in a nozzle advancing direction; and
a component-release-force obtaining means configured to obtain a component release force that releases the electronic component from the suction nozzle due to increase of pressure in the suction nozzle (60; 350; 406).

8. Electronic-component mounting machine according to at least one of the preceding claims 5 to 7, wherein the elimination effect reducer comprises a pressure sensor (126) configured to detect pressure in the mating portion.

9. Electronic-component mounting machine according to at least one of the preceding claims 4 to 8, wherein the pressing-force-change obtaining means comprises:
an implementation-start-timing obtaining means (256) configured to obtain an implementation start timing of the elimination of the negative pressure; and
a pressing-force-change estimator configured to estimate the negative-pressure-elimination-caused pressing force change after the implementation start timing of the elimination of the negative pressure which is obtained by the implementation-start-timing obtaining means.

10. Electronic-component mounting machine according to at least one of the preceding claims 1 to 9, wherein the elimination effect reducer comprises:
an implementation-start-timing obtaining means (256) configured to obtain the implementation start timing of the elimination of the negative pressure; and
a second actuator controller (256) configured to control the actuator to reduce a force that advances the suction nozzle of the nozzle advancing device, when a set length of time is elapsed from the implementation start timing of the elimination of the negative pressure which is obtained by the implementation-start-timing obtaining means.

11. Electronic-component mounting machine according to at least one of the preceding claims 1 to 10, wherein the elimination effect reducer comprises:
a force controller (274, 278, 210) configured to control an actuation force of the actuator to adjust the pressing force with which the electronic component is pressed against the substrate held by the suction nozzle, to an appropriate pressing force that is set in advance;
a position controller (208, 276, 278) configured to adjust a position of the actuator to a target position;
a controller switcher (276, 280) configured to, after the pressing force reaches the appropriate pressing force by the control of the force controller, switch from the force controller to the position controller in a state in which a position of the actuator which corresponds to the appropriate pressing force is set at the target position; and
a switching-timing-dependent valve controller (204, 282) configured to, after the switching from the force controller to the position controller by the controller switcher, eliminate the negative pressure in the suction nozzle by isolating the suction nozzle from the negative-pressure supply source and switching the valve device to a state in which the suction nozzle communicates with the negative-pressure eliminating source.

12. Electronic-component mounting machine according to at least one of the preceding claims 1 to 11, further comprising:
a substrate holding device (26) configured to hold the substrate;
a component supply device (14) configured to supply the electronic component; and
a mounting device (28) configured to receive the electronic component from the component supply device and mount the electronic component onto the substrate held by the substrate holding device,
the mounting device comprising a mounting head (30; 400),
the mounting head comprising:
a head main body (50);
an up/down member (54, 162) movable in an up and down direction with a guide of the head main body;
a first elevating and lowering device (160) configured to elevate and lower the up/down member with respect to the head main body;
a component holder (60) capable of holding the electronic component, the up/down member being configured to hold the component holder such that the component holder is movable in the up and down direction relative to the up/down member; and
a second elevating and lowering device (190) movable with the up/down member by the first elevating and lowering device to elevate and lower the component holder relative to the up/down member,
wherein the suction nozzle constitutes the component holder, and the second elevating and lowering device constitutes the actuator.

13. Electronic-component mounting machine according to claim 12,
wherein the mounting head further comprises:
a rotary body (52; 434) held by the head main body rotatably about a rotation axis and holding a plurality of the suction nozzles along a circle centered about the rotation axis such that each of the plurality of the suction nozzles is movable in an axial direction thereof; and
a rotary-body rotating device (142) configured to rotate the rotary body about the rotation axis to position one of the plurality of the suction nozzles selectively to a component mounting position, and
wherein the up/down member, the first elevating and lowering device, and the second elevating and lowering device are configured to elevate and lower the one of the plurality of the suction nozzles which has been positioned at the component mounting position, with respect to the substrate held by the substrate holding device.

14. Method for mounting an electronic component (220; 436) to a substrate by means of an electronic-component mounting machine according to one of the preceding claims 1 to 13, wherein upon elimination of the negative pressure for releasing the electronic component (220; 436) from the suction nozzle by the negative pressure eliminator (214, 254, 282, 544), a force for pressing the component against the substrate is reduced by the elimination effect reducer (216, 256, 272, 546).

15. Method according to claim 14, wherein the pressing force reduction is based on obtainment of
a force for releasing the electronic component from the suction nozzle (60, 350, 406) due to the elimination of the negative pressure, as a multiplication product of an area of a pressure receiving surface of the component (220, 436) and the pressure in the mating portion (98, 372), and
a force for advancing the suction nozzle, as a multiplication product of pressure increment in the mating portion (98, 372) and an area of a pressure receiving surface of the suction nozzle (60, 350, 406) which receives the pressure in the mating portion in a nozzle advancing direction.

16. Method according to claims 14 or 15, wherein upon elimination of the negative pressure, vacuum break is implemented to speedily eliminate negative pressure by supplying positive pressure to the suction nozzle placing the electronic component (220; 436) on the substrate.

## Patentansprüche

1. Montagemaschine (10) für eine elektronische Komponente, umfassend: eine Saugdüse (60; 350; 406), die dazu konfiguriert ist, eine elektronische Komponente (220; 436) unter Verwendung von negativem Druck anzusaugen und zu halten; eine Düsenbeförderungseinrichtung, umfassend mindestens ein Betätigungselement (84, 192), wobei die Montagemaschine für eine elektronische Komponente zu Folgendem konfiguriert ist: Veranlassen, dass die Düsenbeförderungseinrichtung die Saugdüse, welche die Komponente hält, befördert, um die elektronische Komponente gegen ein Substrat (22) zu pressen; und Eliminieren des negativen Drucks in der Saugdüse, um die elektronische Komponente freizugeben und die elektronische Komponente auf dem Substrat zu montieren,
wobei die Montagemaschine für eine elektronische Komponente des Weiteren umfasst:
eine Ventilvorrichtung (120), die zwischen (i) der Saugdüse und (ii) einer Versorgungsquelle mit negativem Druck (122), die dazu konfiguriert ist, den negativen Druck zu liefern, und einer Eliminierungsquelle des negativen Drucks (124, 125) angeordnet ist, die dazu konfiguriert ist, den negativen Druck zu eliminieren, wobei die Ventilvorrichtung dazu konfiguriert ist, mindestens eines aus der Zuführung des negativen Drucks zu der Saugdüse und der Eliminierung des negativen Drucks zu steuern; und
eine Steuervorrichtung (202; 252; 271; 543), die dazu konfiguriert ist, die Ventilvorrichtung und die Düsenbeförderungsvorrichtung zu steuern,
wobei die Steuervorrichtung umfasst:
einen Eliminator für negativen Druck (214; 254; 282; 544), der dazu konfiguriert ist, die Ventilvorrichtung (120) so zu steuern, dass die Saugdüse (60; 350; 406) die elektronische Komponente (220; 436) freigibt; und
einen Reduzierer für den Eliminierungseffekt (216; 256; 272; 546), der dazu konfiguriert ist, die Düsenbeförderungsvorrichtung so zu steuern, dass zumindest ein Teil des Effekts der Eliminierung des negativen Drucks, der durch den Eliminator für negativen Druck bewirkt wird, an einer Anpresskraft eliminiert wird, mit der die elektronische Komponente gegen das Substrat gepresst wird.

2. Montagemaschine für eine elektronische Komponente nach Anspruch 1,
wobei die Eliminierungsquelle des negativen Drucks eine Versorgungsquelle mit positivem Druck umfasst, die dazu konfiguriert ist, positiven Druck zu liefern, und
wobei der Reduzierer für den Eliminierungseffekt einen Reduzierer für den Vakuumunterbrechungseffekt umfasst, der dazu konfiguriert ist, zumindest einen Teil des Effekts der Vakuumunterbrechung zu reduzieren, die den positiven Druck zu der Saugdüse leitet, um den negativen Druck schnell zu eliminieren.

3. Montagemaschine für eine elektronische Komponente nach Anspruch 1 oder 2, wobei der Reduzierer für den Eliminierungseffekt umfasst: eine erste Betätigungselementsteuerung, die dazu konfiguriert ist, den Effekt der Eliminierung des negativen Drucks auf die Anpresskraft zu reduzieren, indem in eine Steuerung für das Betätigungselement mindestens eines aus Folgendem integriert wird: eine durch die Eliminierung des negativen Drucks bewirkte Änderung der Anpresskraft, die zu einer Änderung der Anpresskraft aufgrund der Eliminierung des negativen Drucks führt, die durch den Eliminator für negativen Druck bewirkt wird; und einen Implementierungsstartzeitpunkt für die Eliminierung des negativen Drucks.

4. Montagemaschine für eine elektronische Komponente nach mindestens einem der vorhergehenden Ansprüche 1 bis 3, wobei der Reduzierer für den Eliminierungseffekt (216; 256; 272; 546) umfasst:
ein Anpresskraftänderungserzielungsmittel, das dazu konfiguriert ist, eine durch die Eliminierung des negativen Drucks bewirkte Änderung der Anpresskraft zu erzielen, die zu einer Änderung der Anpresskraft der elektronischen Komponente auf das Substrat aufgrund der Eliminierung des negativen Drucks führt, die durch den Eliminator für negativen Druck bewirkt wird; und
eine erste Betätigungselementsteuerung, die dazu konfiguriert ist, das Betätigungselement zur Reduzierung einer Kraft anzusteuern, welche die Saugdüse (60; 350; 406) der Düsenbeförderungsvorrichtung befördert, um eine Größe, die mindestens einem Anteil der durch die Eliminierung des negativen Drucks bewirkten Änderung der Anpresskraft entspricht, die durch das Anpresskraftänderungserzielungsmittel erzielt wird.

5. Montagemaschine für eine elektronische Komponente nach mindestens einem der vorhergehenden Ansprüche 1 bis 4, des Weiteren umfassend einen Düsenhalter (62, 82; 366, 370; 402), der gleitfähig auf die Saugdüse (60; 350 406) aufgesetzt ist und die Saugdüse (60; 350; 406) so hält, dass der Düsenhalter (62; 82; 366, 370; 402) und die Saugdüse (60; 350; 406) relativ zu einander in einer axialen Richtung des Düsenhalters (62, 82; 366, 370; 402) verschiebbar sind, wobei zumindest der negative Druck von einer Seite des Düsenhalters (62, 82; 366, 370; 402) zu einer Seite der Saugdüse über einen Kopplungsteil (98; 372) des Düsenhalters (62, 82; 366, 370; 402) und der Saugdüse (60; 350; 406) zugeführt wird.

6. Montagemaschine für eine elektronische Komponente nach Anspruch 5,
wobei ein Anschlag (112; 366) und ein Druckelement (84; 362) zwischen dem Düsenhalter (62, 82; 366, 370; 402) und der Saugdüse (60; 350; 406) angeordnet sind, wobei der Anschlag (112; 366) dazu konfiguriert ist, eines aus einer Rückzugsgrenze und einer Vorschubgrenze der Saugdüse (60; 350; 406) bezüglich des Düsenhalters (62, 82; 366, 370; 402) zu definieren, und das Druckelement dazu konfiguriert ist, die Saugdüse (60; 350; 406) bezüglich des Düsenhalters (62, 82; 366, 370; 402) in Richtung des Anschlags (112; 366) zu drücken, und
wobei zumindest das Druckelement (84; 362) und das Betätigungselement (192) die Düsenbeförderungsvorrichtung bilden.

7. Montagemaschine für eine elektronische Komponente nach Anspruch 5 oder 6,
wobei der Reduzierer für den Eliminierungseffekt umfasst: ein Anpresskraftänderungserzielungsmittel, das dazu konfiguriert ist, eine durch die Eliminierung des negativen Drucks bewirkte Änderung der Anpresskraft zu erzielen, die zu einer Änderung der Anpresskraft der elektronischen Komponente auf das Substrat aufgrund der Eliminierung des negativen Drucks führt, und
wobei das Anpresskraftänderungserzielungsmittel umfasst:
ein Mittel zum Erhalten der Düsenbeförderungskraft, das dazu konfiguriert ist, eine Düsenbeförderungskraft aufgrund der Eliminierung des negativen Drucks zu erhalten, als ein Multiplikationsprodukt eines Druckinkrements in dem Kopplungsteil und einem Bereich einer Druckaufnahmefläche der Saugdüse, die den Druck in dem Kopplungsteil in einer Düsenbeförderungsrichtung aufnimmt; und
ein Mittel zum Erhalten einer Komponentenfreigabekraft, das dazu konfiguriert ist, eine Komponentenfreigabekraft zu erhalten, welche die elektronische Komponente von der Saugdüse aufgrund einer Druckerhöhung in der Saugdüse (60; 350; 406) freigibt.

8. Montagemaschine für eine elektronische Komponente nach mindestens einem der vorhergehenden Ansprüche 5 bis 7, wobei der Reduzierer für den Eliminierungseffekt einen Drucksensor (126) umfasst, der dazu konfiguriert ist, Druck in dem Kopplungsteil zu ermitteln.

9. Montagemaschine für eine elektronische Komponente nach mindestens einem der vorhergehenden Ansprüche 4 bis 8, wobei das Anpresskraftänderungserzielungsmittel umfasst:
ein Mittel zum Erhalten eines Implementierungsstartzeitpunkts (256), das dazu konfiguriert ist, einen Implementierungsstartzeitpunkt der Eliminierung des negativen Drucks zu erzielen; und
einen Anpresskraftänderungsschätzer, der dazu konfiguriert ist, die durch die Eliminierung des negativen Drucks bewirkte Änderung der Antriebskraft nach dem Implementierungsstartzeitpunkt der Eliminierung des negativen Drucks zu schätzen, der von dem Mittel zum Erhalten des Implementierungsstartzeitpunkts erhalten wird.

10. Montagemaschine für eine elektronische Komponente nach mindestens einem der vorhergehenden Ansprüche 1 bis 9, wobei der Reduzierer für den Eliminierungseffekt umfasst:
ein Mittel zum Erhalten eines Implementierungsstartzeitpunkts (256), das dazu konfiguriert ist, den Implementierungsstartzeitpunkt der Eliminierung des negativen Drucks zu erhalten; und
eine zweite Betätigungselementsteuerung (256), die dazu konfiguriert ist, das Betätigungselement zur Reduzierung einer Kraft anzusteuern, die die Saugdüse der Düsenbeförderungsvorrichtung befördert, wenn eine eingestellte Zeitspanne seit dem Implementierungsstartzeitpunkt der Eliminierung des negativen Drucks verstrichen ist, der durch das Mittel zum Erhalten des Implementierungsstartzeitpunkt erhalten wird.

11. Montagemaschine für eine elektronische Komponente nach mindestens einem der vorhergehenden Ansprüche 1 bis 10, wobei der Reduzierer für den Eliminierungseffekt umfasst:
eine Kraftsteuerung (274, 278, 210), die dazu konfiguriert ist, eine Betätigungskraft des Betätigungselements zu steuern, um die Anpresskraft, mit der die elektronische Komponente gegen das Substrat gepresst wird, die von der Saugdüse gehalten wird, auf eine geeignete, vorab eingestellte Anpresskraft anzupassen;
eine Positionssteuerung (208, 276, 278), die dazu konfiguriert ist, eine Position des Betätigungselements zu einer Zielposition anzupassen;
einen Steuerungsschalter (276, 280), der dazu konfiguriert ist, nachdem die Anpresskraft die geeignete Anpresskraft durch die Steuerung der Kraftsteuerung erreicht hat, von der Kraftsteuerung auf die Positionssteuerung in einem Zustand umzuschalten, in dem eine Position des Betätigungselements, die der geeigneten Anpresskraft entspricht, auf die Zielposition eingestellt ist; und
eine schaltzeitpunktabhängige Ventilsteuerung (204, 282), die dazu konfiguriert ist, nach dem Umschalten von der Kraftsteuerung auf die Positionssteuerung durch den Steuerungsschalter, den negativen Druck in der Saugdüse durch Isolieren der Saugdüse von der Versorgungsquelle mit negativem Druck zu eliminieren und die Ventilvorrichtung auf einen Zustand umzuschalten, in dem die Saugdüse mit der Eliminierungsquelle für negativen Druck kommuniziert.

12. Montagemaschine für eine elektronische Komponente nach mindestens einem der vorhergehenden Ansprüche 1 bis 11, des Weiteren umfassend:
eine Substrathaltevorrichtung (26), die dazu konfiguriert ist, das Substrat zu halten;
eine Komponentenzufuhrvorrichtung (14), die dazu konfiguriert ist, die elektronische Komponente zuzuführen; und
eine Montagevorrichtung (28), die dazu konfiguriert ist, die elektronische Komponente von der Komponentenzufuhrvorrichtung aufzunehmen und die elektronische Komponente auf das von der Substrathaltevorrichtung gehaltene Substrat zu montieren,
wobei die Montagevorrichtung einen Montagekopf (30; 400) umfasst,
wobei der Montagekopf umfasst:
einen Kopfhauptkörper (50);
ein Auf/Ab-Element (54, 162), das in einer Richtung nach oben und unten mit einer Führung des Kopfhauptkörpers beweglich ist;
eine erste Hebe- und Absenkvorrichtung (160), die dazu konfiguriert ist, das Auf/Ab-Element bezüglich des Kopfhauptkörpers anzuheben und abzusenken;
einen Komponentenhalter (60), der dazu in der Lage ist, die elektronische Komponente zu halten, wobei das Auf/Ab-Element dazu konfiguriert ist, den Komponentenhalter so zu halten, dass der Komponentenhalter in der Richtung nach oben und unten relativ zu dem Auf/Ab-Element beweglich ist; und
eine zweite Hebe- und Absenkvorrichtung (190), die mit dem Auf/Ab-Element durch die erste Hebe- und Absenkvorrichtung beweglich ist, um den Komponentenhalter relativ zu dem Auf/Ab-Element anzuheben und abzusenken,
wobei die Saugdüse den Komponentenhalter bildet, und die zweite Hebe- und Absenkvorrichtung das Betätigungselement bildet.

13. Montagemaschine für eine elektronische Komponente nach Anspruch 12,
wobei der Montagekopf des Weiteren umfasst:
einen Drehkörper (52, 434), der von dem Kopfhauptkörper drehbar um eine Drehachse gehalten wird und eine Vielzahl der Saugdüsen entlang einem Kreis hält, der um die Drehachse herum zentriert ist, so dass jeder aus der Vielzahl von Saugdüsen in einer axialen Richtung beweglich ist; und
eine Drehkörper-Drehvorrichtung (142), die dazu konfiguriert ist, den Drehkörper um die Drehachse zu drehen, um eine aus der Vielzahl von Saugdüsen selektiv auf eine Komponentenmontageposition zu positionieren, und
wobei das Auf/Ab-Element, die erste Hebe- und Absenkvorrichtung und die zweite Hebe- und Absenkvorrichtung dazu konfiguriert sind, die eine aus der Vielzahl von Saugdüsen, die auf der Komponentenmontageposition positioniert ist, bezüglich des Substrats, das von der Substrathaltevorrichtung gehalten wird, anzuheben und abzusenken.

14. Montageverfahren für eine elektronische Komponente (220; 436) an einem Substrat mithilfe einer Montagemaschine für eine elektronische Komponente nach einem der vorhergehenden Ansprüche 1 bis 13, wobei bei der Eliminierung des negativen Drucks zur Freigabe der elektronischen Komponente (220; 436) von der Saugdüse durch den Eliminator für negativen Druck (214, 254, 282, 544) eine Kraft zum Anpressen der Komponente gegen das Substrat durch den Reduzierer für den Eliminierungseffekt (216, 256, 272, 546) reduziert wird.

15. Verfahren nach Anspruch 14, wobei die Reduzierung der Anpresskraft auf dem Erhalten
einer Kraft zum Freigeben der elektronischen Komponente von der Saugdüse (60, 350, 406) aufgrund der Eliminierung des negativen Drucks als ein Multiplikationsprodukt von einem Bereich einer Druckaufnahmefläche der Komponente (220, 436) und dem Druck in dem Kopplungsteil (98, 372) basiert, und
einer Kraft zum Befördern der Saugdüse, als Multiplikationsprodukt des Druckinkrements in dem Kopplungsteil (98, 372) und einem Bereich einer Druckaufnahmefläche der Saugdüse (60, 350, 406), die den Druck in dem Kopplungsteil in einer Düsenbeförderungsrichtung aufnimmt.

16. Verfahren nach Anspruch 14 oder 15, wobei bei Eliminierung des negativen Drucks eine Vakuumunterbrechung implementiert wird, um den negativen Druck durch Zuführen eines positiven Drucks zu der Saugdüse zügig zu eliminieren, welche die elektronische Komponente (220; 436) auf dem Substrat platziert.

## Revendications

1. Machine de montage de composant électronique (10) comprenant: une buse d'aspiration (60; 350; 406) configuré pour aspirer et maintenir un composant électronique (220; 436) en utilisant une pression négative;
et un dispositif d'avancement de buse comprenant au moins un actionneur (84, 192), la machine de montage de composant électronique étant configurée pour: que le dispositif d'avancement de buse fasse avancer la buse d'aspiration maintenant le composant électronique pour comprimer le composant électronique contre un substrat (22); et éliminer la pression négative dans la buse d'aspiration afin de libérer le composant électronique et monter le composant électronique sur le substrat,
la machine de montage de composant électronique comprenant en outre:
un dispositif de soupape (120) prévu entre (i) la buse d'aspiration et (ii) une source d'alimentation en pression négative (122) configurée pour fournir la pression négative et une source d'élimination de pression négative (124, 125) configurée pour éliminer la pression négative, le dispositif de soupape étant configuré pour commander au moins une alimentation de la pression négative vers la buse d'aspiration et l'élimination de la pression négative; et
un dispositif de commande (202; 252; 271; 543) configuré pour commander le dispositif de soupape et le dispositif d'avancement de buse,
le dispositif de commande comprenant:
un éliminateur de pression négative (214; 254; 282; 544) configuré pour commander le dispositif de soupape (120) afin que la buse d'aspiration (60; 350; 406) libère le composant électronique (220; 436); et
un réducteur d'effet d'élimination (216; 256; 272; 546) configuré pour commander au dispositif d'avancement de buse d'éliminer au moins une partie de l'effet de l'élimination de pression négative provoquée par l'éliminateur de pression négative, sur une force de pression avec laquelle le composant électronique est comprimé contre le substrat.

2. Machine de montage de composant électronique selon la revendication 1,
dans laquelle la source d'élimination de pression négative comprend une source d'alimentation à pression positive configurée pour fournir une pression positive, et
dans laquelle le réducteur d'effet d'élimination comprend un réducteur d'effet de cassage de vide configuré pour réduire au moins une partie de l'effet de cassage du vide qui fournit la pression positive à la buse d'aspiration pour éliminer rapidement la pression négative.

3. Machine de montage de composant électronique selon les revendications 1 ou 2, où le réducteur d'effet d'élimination comprend; un premier contrôleur d'actionneur configuré pour réduire l'effet d'élimination de la pression négative sur la force de pression en incorporant, dans un élément de commande de l'actionneur, au moins l'un des éléments suivants: un changement de force de pression causé par l'élimination de la pression négative conduisant à une modification de la force de pression suite à l'élimination de la pression négative provoquée par l'éliminateur de pression négative; et un minutage de démarrage de l'élimination de la pression négative.

4. Machine de montage de composant électronique selon l'une au moins des revendications précédentes 1 à 3, où le réducteur d'effet d'élimination (216; 256; 272; 546) comprend:
un moyen d'obtention de changement de force de pression configuré pour obtenir un changement de force de pression provoquée par l'élimination de la pression négative conduisant à un changement de la force de pression du composant électronique sur le substrat suite à l'élimination de la pression négative provoquée par l'éliminateur de pression négative ; et
un premier contrôleur d'actionneur configuré pour commander l'actionneur pour réduire une force qui fait avancer la buse d'aspiration (60; 350; 406) du dispositif d'avancement de la buse, d'un degré correspondant à au moins une partie du changement de la force de pression obtenu par l'élimination de la pression négative obtenu par le moyen d'obtention du changement de force de pression.

5. Machine de montage de composant électronique selon au moins l'une des revendications précédentes 1 à 4, comprenant en outre un porte-buse (62, 82; 366, 370; 402) monté de façon coulissante sur la buse d'aspiration (60; 350; 406) et en maintenant la buse d'aspiration (60; 350; 406) de sorte que le porte-buse (62, 82; 366, 370; 402) et la buse d'aspiration (60; 350; 406) sont mobiles l'un par rapport à l'autre dans une direction axiale du porte-buse (62, 82; 366, 370; 402),
dans laquelle au moins la pression négative est fournie à partir d'un côté du porte-buse (62, 82; 366, 370; 402) vers un côté de la buse d'aspiration par l'intermédiaire d'une partie accouplement (98; 372) du porte-buse (62, 82; 366, 370; 402) et de la buse d'aspiration (60; 350; 406).

6. Machine de montage de composant électronique selon la revendication 5,
dans laquelle un bouchon (112; 366) et un élément de poussée (84; 362) sont prévus entre le porte-buse (62, 82; 366, 370; 402) et la buse d'aspiration (60; 350; 406), dans laquelle le bouchon (112, 366) est configuré pour définir un élément parmi une limite de rétraction et une limite d'avancement de la buse d'aspiration (60; 350; 406) par rapport au porte-buse (62, 82; 366, 370; 402) et l'élément de poussée est configuré pour pousser la buse d'aspiration (60; 350; 406) par rapport au porte-buse (62, 82; 366, 370; 402) vers le bouchon (112; 366) et
dans laquelle au moins l'élément de poussée (84; 362) et l'actionneur (192) constituent le dispositif d'avancement de buse.

7. Machine de montage de composant électronique selon les revendications 5 ou 6, dans laquelle le réducteur d'effet d'élimination comprend: un moyen d'obtention de changement de force de pression configuré pour obtenir un changement de force de pression provoqué par l'élimination de la pression négative conduisant à un changement de la force de pression du composant électronique sur le substrat suite à l'élimination de la pression négative et
dans laquelle le moyen d'obtention du changement de force de pression comprend:
un moyen d'obtention de la force d'avancement de la buse configuré pour obtenir une force d'avancement de la buse due à l'élimination de la pression négative, comme produit de multiplication de l'incrément de pression dans la partie accouplement et une partie d'une surface de réception de pression de la buse d'aspiration qui reçoit la pression dans la partie accouplement dans une direction d'avancement de la buse; et
un moyen d'obtention de force de libération de composant configuré pour obtenir une force de libération de composant qui libère le composant électronique de la buse d'aspiration suite à l'augmentation de pression dans la buse d'aspiration (60; 350; 406).

8. Machine de montage de composant électronique selon au moins l'une des revendications précédentes 5 à 7, dans laquelle le réducteur d'effet d'élimination comprend un capteur de pression (126) configuré pour détecter la pression dans la partie accouplement.

9. Machine de montage de composant électronique selon au moins l'une des revendications précédentes 4 à 8, dans laquelle le moyen d'obtention du changement de force de pression comprend:
un moyen d'obtention de minutage de démarrage (256) configuré pour obtenir un minutage de démarrage de l'élimination de la pression négative; et un dispositif d'estimation de changement de force de pression configuré pour estimer le changement de force de pression provoqué par l'élimination de la pression négative après le minutage de démarrage de l'élimination de la pression négative qui est obtenue par le moyen d'obtention de minutage de démarrage.

10. Machine de montage de composant électronique selon l'une au moins des revendications précédentes 1 à 9, où le réducteur d'effet d'élimination comprend:
un moyen d'obtention de minutage de démarrage (256) configuré pour obtenir le minutage de démarrage de l'élimination de la pression négative; et un second contrôleur d'actionneur (256) configuré pour commander à l'actionneur de réduire une force qui fait avancer la buse d'aspiration du dispositif d'avancement de la buse, lorsqu'un laps de temps définie s'est écoulé depuis le minutage de démarrage de l'élimination de la pression négative qui est obtenue par le moyen d'obtention du minutage de démarrage.

11. Machine de montage de composant électronique selon au moins l'une des revendications précédentes 1 à 10, dans laquelle le réducteur d'effet d'élimination comprend:
un dispositif de commande de force (274, 278, 210) configuré pour commander une force d'actionnement de l'actionneur pour ajuster la force de pression avec laquelle le composant électronique est comprimé contre le substrat maintenu par la buse d'aspiration, à une force de pression appropriée qui est définie à l'avance;
un dispositif de commande de position (208, 276, 278) configuré pour ajuster une position de l'actionneur à une position cible;
un commutateur de dispositif de commande (276, 280) configuré pour, une fois que la force de pression a atteint la force de pression appropriée par la commande du dispositif de commande de force, passer du dispositif de commande de force au dispositif de commande de position dans un état dans lequel une position de l'actionneur qui correspond à la force de pression appropriée réglée sur la position cible; et un dispositif de commande de soupape dépendant du minutage de commutation (204, 282) configuré pour, après commutation du dispositif de commande de force vers le dispositif de commande de position par le commutateur de dispositif de commande, éliminer la pression négative dans la buse d'aspiration en isolant la buse d'aspiration de la source d'alimentation en pression négative et commutant le dispositif de soupape vers un état dans lequel la buse d'aspiration communique avec la source d'élimination en pression négative.

12. Machine de montage de composant électronique selon au moins l'une des revendications précédentes 1 à 11, comprenant en outre:
un dispositif de maintien de substrat (26) configuré pour maintenir le substrat;
un dispositif d'alimentation de composant (14) configuré pour fournir le composant électronique; et
un dispositif de montage (28) configuré pour recevoir le composant électronique à partir du dispositif d'alimentation de composant et monter le composant électronique sur le substrat maintenu par le dispositif de maintien de substrat,
le dispositif de montage comprenant une tête de montage (30; 400),
la tête de montage comprenant:
un corps principal de tête (50);
un élément ascendant/descendant (54, 162) mobile en direction ascendante et descendante avec un guide du corps principal de tête;
un premier dispositif d'élévation et d'abaissement (160) configuré pour relever et abaisser l'élément ascendant/descendant par rapport au corps principal de tête;
un porte-composant (60) capable de maintenir le composant électronique, l'élément ascendant/descendant étant configuré pour maintenir le porte-composant pour que le porte-composant soit mobile en direction ascendante et descendante par rapport à l'élément ascendant/descendant; et un second dispositif d'élévation et d'abaissement (190) mobile avec l'élément ascendant/descendant par le premier dispositif d'élévation et d'abaissement pour relever et abaisser le porte-composant par rapport à l'élément ascendant/descendant,
dans laquelle la buse d'aspiration constitue le porte-composant, et le second dispositif d'élévation et d'abaissement constitue l'actionneur.

13. Machine de montage de composant électronique selon la revendication 12, dans laquelle la tête de montage comprend en outre:
un corps rotatif (52; 434) maintenu par le corps principal de tête de façon à pouvoir tourner autour d'un axe de rotation et contenant une pluralité des buses d'aspiration le long d'un cercle centré autour de l'axe de rotation de telle sorte que chacune de la pluralité des buses d'aspiration est mobile dans une direction axiale de celui-ci; et
un dispositif rotatif de corps rotatif (142) configuré pour faire tourner le corps rotatif autour de l'axe de rotation pour positionner l'une parmi la pluralité des buses d'aspiration de manière sélective vers une position de montage de composant et
dans laquelle l'élément ascendant/descendant, le premier dispositif d'élévation et d'abaissement et le second dispositif d'élévation et d'abaissement sont configurés pour élever et abaisser l'une de la pluralité des buses d'aspiration qui a été positionnée en position de montage de composant par rapport au substrat maintenu par le dispositif de maintien de substrat.

14. Procédé de montage d'un composant électronique (220; 436) sur un substrat au moyen d'une machine de montage de composant électronique selon l'une quelconque des revendications précédentes 1 à 13, dans lequel lors de l'élimination de la pression négative pour libérer le composant électronique (220; 436) à partir de la buse d'aspiration par l'éliminateur de pression négative (214, 254, 282, 544), une force de pression du composant contre le substrat est réduite par le réducteur d'effet d'élimination (216, 256, 272, 546).

15. Procédé selon la revendication 14, dans lequel la réduction de la force de pression est fondée sur l'obtention d'une force de libération du composant électronique à partir de la buse d'aspiration (60, 350, 406) suite à la suppression de la pression négative, comme produit de multiplication d'une zone d'une surface de réception de pression de l'élément (220, 436) et de la pression dans la partie accouplement (98, 372), et
une force pour faire avancer la buse d'aspiration, comme produit de multiplication de l'incrément de pression dans la partie accouplement (98, 372) et d'une zone d'une surface de réception de pression de la buse d'aspiration (60, 350, 406) qui reçoit la pression dans la partie accouplement dans une direction d'avancement de buse.

16. Procédé selon les revendications 14 ou 15, dans lequel lors de l' élimination de la pression négative, un cassage de vide est enclenché pour éliminer rapidement la pression négative en fournissant une pression positive à la buse d'aspiration déposant le composant électronique (220; 436) sur le substrat.
